(19) Europäisches Patentamt
European Patent Office
Office européen des brevets

(11) **EP 1 457 471 B1**

(12) **EUROPEAN PATENT SPECIFICATION**

(45) Date of publication and mention of the grant of the patent:
**26.02.2014 Bulletin 2014/09**

(51) Int Cl.:
***C04B 35/495*** *(2006.01)* ***H01L 41/187*** *(2006.01)*

(21) Application number: **04006019.6**

(22) Date of filing: **12.03.2004**

(54) **Crystal oriented ceramics and production method of same**

Keramik mit Kristallorientierung und Verfahren zu ihrer Herstellung

Céramiques à orientation cristalline et procédés pour leur préparation

(84) Designated Contracting States:
**DE FR GB**

(30) Priority: **14.03.2003 JP 2003069665**

(43) Date of publication of application:
**15.09.2004 Bulletin 2004/38**

(73) Proprietor: **DENSO CORPORATION**
**Kariya-city,**
**Aichi-pref. 448-8661 (JP)**

(72) Inventors:
• **Nonoyama, Tatsuhiko**
**Kariya-city**
**Aichi-pref. 448-8661 (JP)**
• **Nagaya, Toshiatsu**
**Kariya-city**
**Aichi-pref. 448-8661 (JP)**
• **Takao, Hisaaki**
**Nagakute**
**Nagakute-cho**
**Aichi-ken 480-1192 (JP)**
• **Homma, Takahiko**
**Nagakute**
**Nagakute-cho**
**Aichi-ken 480-1192 (JP)**
• **Saito, Yasuyoshi**
**Nagakute**
**Nagakute-cho**
**Aichi-ken 480-1192 (JP)**
• **Takatori, Kazumasa**
**Nagakute**
**Nagakute-cho**
**Aichi-ken 480-1192 (JP)**
• **Nakamura, Masaya**
**Kariya-city**
**Aichi-pref. 448-8661 (JP)**

(74) Representative: **TBK**
**Bavariaring 4-6**
**80336 München (DE)**

(56) References cited:
**EP-A- 1 032 057 EP-A- 1 382 588**

• **PATENT ABSTRACTS OF JAPAN vol. 007, no. 148 (E-184), 29 June 1983 (1983-06-29) -& JP 58 060582 A (ASAHI GLASS KK), 11 April 1983 (1983-04-11)**
• **DATABASE WPI Section Ch, Week 197623 Thomson Scientific, London, GB; Class L02, AN 1976-42485X XP002253231 -& JP 49 033907 A (TDK ELECTRONICS CO LTD) 28 March 1974 (1974-03-28)**
• **PATENT ABSTRACTS OF JAPAN vol. 1995, no. 06, 31 July 1995 (1995-07-31) -& JP 07 082024 A (MURATA MFG CO LTD), 28 March 1995 (1995-03-28)**

**Description**

BACKGROUND OF THE INVENTION

1. Field of the Invention

The present invention relates to a method for producing crystal oriented ceramics, and more particularly, to crystal oriented ceramics, and a production method thereof, suitable for use as various types of piezoelectric materials used in sensors such as acceleration sensors, pyroelectric sensors, ultrasonic sensors, electrical field sensors, temperature sensors, gas sensors, knocking sensors, yaw rate sensors, air bag sensors and piezoelectric gyro sensors, energy conversion elements such as piezoelectric transformers, energy-efficient actuators or energy-efficient resonators such as piezoelectric actuators, ultrasonic motors and resonators, and capacitors, bimorphic piezoelectric elements, vibration pickups, piezoelectric microphones, piezoelectric ignition elements, sonar, piezoelectric buzzers, piezoelectric speakers, vibrators and filters, or dielectric materials used in capacitors and multilayer capacitors, thermoelectric conversion materials and ion conducting materials.

2. Description of the Related Art

Piezoelectric materials are materials that realize piezoelectric effects, and their form is classified into single crystals, ceramics, thin films, polymers and composites (compound materials). Among these piezoelectric materials, since piezoelectric ceramics in particular offer high performance, have a large degree of freedom of shape and facilitate easy material design, they are widely used in the fields of electronics and mechatronics.
Piezoelectric ceramics are subjected to so-called polarization treatment in which an electric field is applied to ferroelectric ceramics to orient the direction of the ferroelectric domains in a fixed direction. In the case of piezoelectric ceramics, in order to orient spontaneous polarization in a fixed direction by polarization treatment, an isotropic perovskite crystal structure is advantageous since it allows the direction of spontaneous polarization to be three-dimensional. Consequently, the majority of piezoelectric ceramics in practical use are isotopic perovskite ferroelectric ceramics.
Known examples of isotropic perovskite ferroelectric ceramics include $Pb(Zr \cdot Ti)O_3$ (to be abbreviated as "PZT"), PZT three-component systems in which lead-base complex perovskite has been added to PZT as a third component, $BaTIO_3$ and $Bi_{0.5}Na_{0.5}TiO_3$ (to be abbreviated as "BNT").
Among these examples, since lead-based piezoelectric ceramics like PZT have higher piezoelectric characteristics compared with other piezoelectric ceramics, they currently account for the majority of piezoelectric ceramics in practical use. However, since they contain the component of lead oxide (PbO), which has a high vapor pressure for elevated temperature, they have the problem of placing a burden on the environment. Consequently, piezoelectric ceramics are being sought that have equivalent piezoelectric characteristics to PZT, but which either contain low levels of lead or are lead-free.
on the other hand, $BaTIO_3$ ceramics have comparatively high piezoelectric characteristics among piezoelectric materials that do not contain lead, and are used for sonar and other applications. In addition, solid solutions of $BaTIO_3$ and other non-lead-based perovskite compounds (e.g., BNT) are known to exhibit comparatively high piezoelectric characteristics. However, these lead-free piezoelectric ceramics have the shortcoming of low piezoelectric characteristics as compared with PZT.
Therefore, various proposals have been made in the past to solve this problem. For example, Japanese Unexamined Patent Publication No. 11-180769 discloses a piezoelectric ceramic material that has the basic composition of (1-x)BNT-BaTiO_3 (wherein, x = 0.06-0.12) and contains 0.5-1.5% by weight of an oxide of a rare earth element (such as $La_2O_3$, $Y_2O_3$ or $Yb_2O_3$).
In addition, Japanese Unexamined Patent Publication No. 2000-272962 discloses a piezoelectric ceramic composition expressed by the general formula: $\{Bi_{0.5}(Na_{1-x}K_x)0.5\}TiO_3$ (wherein, $0.2 \leq x \leq 0.3$), and which contains 2% by weight or less of an additive (such as $Fe_2O_3$, $Cr_2O_3$, $MnO_2$, NiO or $Nb_2O_5$).
In addition, Japanese Unexamined Patent Publication No. 2000-281443 discloses a piezoelectric ceramic composition having for its main component a tungsten bronze complex oxide represented by the general formula: $xNaNbO_3-yBaNb_2O_6-zBiNb_3O_9$ (wherein, x + y + z = 1, and (x,y,z) lies within a predetermined region on a three-component composition diagram), and containing Bi within the total weight at a ratio of 3-6% by weight as metal. In addition, in Japanese Unexamined Patent Publication No. 2000-313664, an alkaline metal-containing niobium oxide-based piezoelectric ceramic composition is disclosed by the present applicant comprising the addition of a compound containing one or more types of the elements selected from Cu, Li and Ta to a solid solution represented by the general formula: $K_{1-x}Na_xNbO_3$ (wherein, x = 0-0.8).
In addition, Japanese Unexamined Patent Publication No. 2002-137966 discloses a piezoelectric ceramic represented by the compositional formula: $(1-x)NaNbO_3 + xMnTiO_3$ (wherein, $0.014 \leq x \leq 0.08$), and which further contains as an auxiliary component 0.5-10 mol% of $KNbO_3$ or $NaNbO_3$ with respect to the compound represented by the compositional formula.

In addition, Japanese Unexamined Patent Publication No. 2001-240471 discloses a piezoelectric ceramic composition containing a main component represented by $Na_xNbO_3$ ($0.95 \leq x \leq 1$), and an auxiliary component represented by the composition formula $A_YBO_f$ (wherein, A represents at least one of K, Na or Li and Bi, B represents at least one of Li, Ti, Nb, Ta or Sb, $0.2 \leq y \leq 1.5$, and f is arbitrary), wherein the content of the auxiliary component is 8 mol% or less, and at least one type of first transition metal element from Sc of atomic number 21 to Zn of atomic number 30 is contained at 0.01-3% by weight as oxide.

In addition, Japanese Unexamined Patent Publication No. 2001-291908 discloses a piezoelectric ceramic composed of $Na_{0.5}Bi_{4.5}Ti_4O_{15}$, which is a type of layered perovskite composite, wherein the c axis is oriented in a single direction, and the piezoelectric ceramic is polarized in the direction perpendicular to the orientation direction of the c axis. In this document, it is described that a piezoelectric ceramic is obtained that is polarized in mutually opposite directions in the in-plane direction of a sheet by forming linear electrodes arranged in parallel on the surface of a green sheet containing a starting material, laminating the green sheet so that the electrodes are mutually overlapping along the direction of lamination, sintering the green sheet laminate while applying pressure in the direction of lamination, and finally applying a direct current electric field between opposing electrodes on the sheet.

In addition, Japanese Unexamined Patent Publication No. 2001-039766 discloses a piezoelectric device composed of $CaBi_4Ti_4O_{15}$, which is a type of layered perovskite composites, wherein the c axis is oriented in a single direction, and the ceramics are polarized in a direction perpendicular to the orientation direction of the c axis, and are formed in the plane parallel to the orientation direction of the c axis and the direction of polarization. It is described in this document that a piezoelectric ceramic is obtained that is polarized in a direction perpendicular to the orientation direction of the c axis in such a way that a raw material powder was calsined, calsined material was coarsely crushed, and then pressed to a cylindrical shape pellet, the pellet was heat treated at 600°C and then fired under uniaxial pressure, a rectangular shape specimen was cut out from the fired pellet so that the direction of uniaxial pressure described above is parallel to the direction of the precimen widthwise edge, and finally the specimen was polarized in the lengthwise direction of the specimen.

In addition, Japanese Unexamined Patent Publication No. 2002-193663 discloses a crystal-oriented perovskite composite expressed by the general formula: $ABO_3$ (wherein, A represents a divalent metal element, and B represents a tetravalent metal element). It is described in this document that a (111) plane- oriented barium titanate sintered compact is obtained by forming a raw material containing $Ba_6Ti_{17}O_{40}$ plate-like powder, $BaTiO_3$ powder and $BaCO_3$ powder into the form of a sheet, laminating this under pressure and sintering the laminate at a predetermined temperature.

Moreover, in Japanese Unexamined Patent Publication No. 11-60333, a piezoelectric ceramic is disclosed by the present applicant that is composed of perovskite ceramic containing rhombohedral crystal for its edge phase (for example, perovskite ceramic in which $Bi_{0.5}K_{0.5}TiO_3$, $BaTiO_3$ or $NaNbO_3$ and so forth is in the form of a solid solution with BNT), and the degree of orientation as determined by the Lotgering method of a pseudo-cubic {100} plane is 30% or more. In addition, this document also discloses a production process of a piezoelectric ceramic comprising mixing a host material A having a plate-like form and composed of a layered perovskite compound ($Bi_4Ti_3O_{12}$), a guest material B having an isotropic perovskite structure or a raw material Q capable of forming guest material B (equiaxial powder of $Bi_{0.5}(Na_{0.85}K_{0.15})_{0.5}TiO_3$), and a guest material C for converting host material A to an isotropic perovskite compound ($Bi_2O_3$ powder, $Na_2CO_3$ powder, $K_2CO_3$ powder and $TiO_2$ powder) and forming these so that host material A is oriented followed by heating and sintering.

The piezoelectric, pyroelectric, dielectric, thermoelectric, electron-conducting and ion-conducting characteristics and so forth (to be generically referred to as "piezoelectric characteristics") of lead-free-based ferroelectrics composed of an isotropic perovskite compound such as $BaTiO_3$, BNT or $K_{1-y}Na_yNbO_3$ ($0 \leq y \leq 1$) are generally inferior to lead-based ferroelectrics represented by PZT. On the other hand, as described in Patent Documents 1-6, sintering properties and piezoelectric characteristics, etc. are known to improve by adding various additives to non-lead-based ferroelectrics.

However, when an isotropic perovskite compound is produced by an ordinary ceramics production process, namely a production process in which a simple compound containing constituent elements is used as the starting material followed by calcining, molding and sintering, the crystal grains in the resulting sintered compact are oriented randomly. Consequently, even in the case of a composition inherently having high piezoelectric characteristics, the piezoelectric characteristics of the resulting sintered compact are inadequate.

In contrast, the piezoelectric characteristics of isotropic perovskite compounds are generally known to vary depending on the direction of the crystal axis. Consequently, if it were possible to orient a crystal axis having high piezoelectric characteristics in a fixed direction, the anisotropy of the piezoelectric characteristics could be maximally utilized, thereby realizing higher performance of piezoelectric ceramics. In actuality, some single crystals composed of lead-free-based ferroelectric materials are known to demonstrate superior piezoelectric characteristics.

However, single crystals have the disadvantage of a high production cost. In addition, single crystals of solid solutions having a complex composition are susceptible to compositional shifts during production, and are unsuitable as practical materials. Moreover, since single crystals have inferior fracture toughness, it is difficult to use them under conditions of high stress, resulting in the problem of limited application.

In addition, as is described in the aforementioned Japanese Unexamined Patent Publication No. 2001-291908 and Japanese Unexamined Patent Publication No. 2001-039766, a specific crystal plane can be oriented by applying uniaxial pressure during sintering. However, this method can only be applied to crystal systems and crystal planes having inherently large anisotropy like those of layered perovskite compounds, and has the disadvantage of being unable for application to crystal systems and crystal planes having a low level of anisotropy like isotropic perovskite compounds.

On the other hand, as is described in the aforementioned Japanese Unexamined Patent Publication No. 2002-193663 and Japanese Unexamined Patent Publication No. 11-60333, according to a method in which a specific crystal plane is oriented using a plate-like powder having a predetermined composition for the reactive template, even in the case of crystal systems and crystal planes having low anisotropy, crystal oriented ceramics in which a specific crystal plane is oriented at a high degree of orientation can be produced both easily and with lower cost.

However, in a method in which a plate-like powder composed of $Ba_6Ti_{17}O_{40}$ or $Bi_4Ti_4O_{12}$ and so forth is used for the reactive template, A site elements (Ba or Bi) and B site elements (Ti) contained in the plate-like powder always remain in the resulting crystal oriented ceramics. Consequently, there are cases in which this method may not be able to realize the most desirable composition in the case of applying to isotropic perovskite-based potassium sodium niobate $(K_{1-y}Na_yNbO_3)$, or solid solutions thereof, exhibiting comparatively high piezoelectric characteristics among these lead-free-based compounds, and there is the risk of piezoelectric characteristics being impaired by unavoidably contained A site elements and/or B site elements.

JP 58 060582 A discloses a piezoelectric ceramic represented by a constitutional formula of $(Na_{1-x}, Li_x)_z$ $(Nb_{1-y}, Sb_y)O_3$ with the composition values of x, y, z within the scope of $0.03 \leq x \leq 0.14$, $0.001 \leq y \leq 0.03$, $0.980 \leq z \leq 1$.

EP 1 032 057 A1 relates to an alkali metal-containing niobate-based piezoelectric material composition comprising a solid solution represented by a composition formula $(ANbO_3)$ (A:Alkalimetal), and at least one additive selected from Cu, Li and Ta.

JP 49 033907 A discloses a ferroelectric piezoelectric ceramic material having the formula $(Li_xNa_{1-x})$ $(Ta_yNb_{1-y})O_3$.

From JP 07 082024 A a piezoelectric ceramic composition of the general formula $(Na_xK_{1-x}(Nb_{1-y}Ta_y)O_3$ $(0.2 \leq x \leq 0.08; 0.0 \leq y \leq 0.5)$.

D5, which is prior art according to Art. 54(3) EPC relates to a piezoelectric ceramic composition having a compound of general formula -$\{Li_x(K_{1-y}Na_y)_{1-x}\}(Nb_{1-z-w}Ta_zSb_w)O_3$ where x, y, z and w are in the ranges of $0 \leq x \leq 0.2, 0 \leq y \leq 1, 0 < z \leq 0.4$ and $0 < w < 0.2$ as a main ingredient.

An object of the present invention is to provide crystal oriented ceramics, and a production method of the same, having for its basic composition isotropic perovskite-based potassium sodium niobate, and exhibiting superior piezoelectric characteristics. In addition, another object of the present invention is to provide crystal, oriented ceramics, and a production method of the same, having for its basic composition isotropic perovskite-based potassium sodium niobate, and in which a specific crystal plane is oriented at a high degree of orientation.

SUMMARY OF THE INVENTION

In order to solve the aforementioned problems, the crystal oriented ceramics as claimed in the present invention is composed of a polycrystalline substance of an isotropic perovskite compound represented by the general formula:

$$\{Li_x(K_{1-y}Na_y)_{1-x}\}\{Nb_{1-z-w}Ta_zSb_w\}O_3 \qquad (1)$$

(wherein, x, y, z and w are respectively $0 \leq x \leq 0.2$, $0 \leq y \leq 1$, $0 \leq z \leq 0.4$, $0 \leq w \leq 0.2$, $x + z + w > 0$), in which, in $ABO_3$, the A site element is K, Na and/or Li, and the B site element is Nb, Sb and/or Ta, and a specific crystal plane of each crystal grain that composes said polycrystal ne substance is oriented wherein the degree of orientation of the pseudo-cubic {100} plane as determined by the Lotgering method is 30% or more.

In isotropic perovskite-based potassium sodium niobate, by substituting a portion of the A site element with a predetermined amount of Li and/or substituting a portion of the B site element with a predetermined amount of Ta and/or Sb, piezoelectric characteristics are improved as compared with the case of not containing these elements.

In addition, when a specific crystal plane is oriented, the piezoelectric $d_{31}$ constant, piezoelectric $g_{31}$ constant and electromechanical coupling coefficient are improved as compared with non-oriented sintered compacts of the same composition.

In addition, the crystal oriented ceramics production method according to the present invention is provided with a mixing step in which a first anisotropic shaped powder, for which the growth plane has lattice coherency with a specific crystal plane of the isotropic perovskite compound described in claim 1, is mixed with a first reaction raw material that reacts with said first anisotropic shaped powder and at least forms the isotropic perovskite compound; a molding step in which the mixture obtained in the mixing step is molded so that the first anisotropic shaped powder is oriented; and, a heat treatment step in which the molded product obtained in the molding step is heated to cause a reaction between the first anisotropic shaped powder and the first reaction raw material.

When a first anisotropic shaped powder that satisfies the predetermined conditions is reacted with a first reaction raw material that has a predetermined composition, anisotropic shaped crystals form composed of the isotropic perovskite compound described in claim 1 that have inherited the orientation azimuth of the first anisotropic shaped powder. Consequently, if the first anisotropic shaped powder is oriented in the molded product and the molded product is heated to a predetermined temperature, a crystal oriented ceramic is obtained that is composed of the isotropic perovskite compound described in claim 1, and in which crystal grains having a specific crystal plane for the growth plane are oriented in a specific direction.

BRIEF DESCRIPTION OF THE DRAWINGS

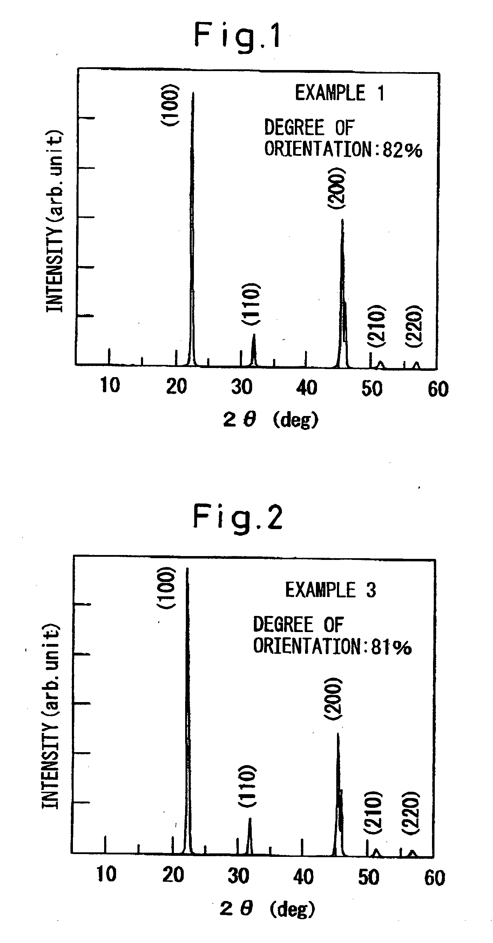

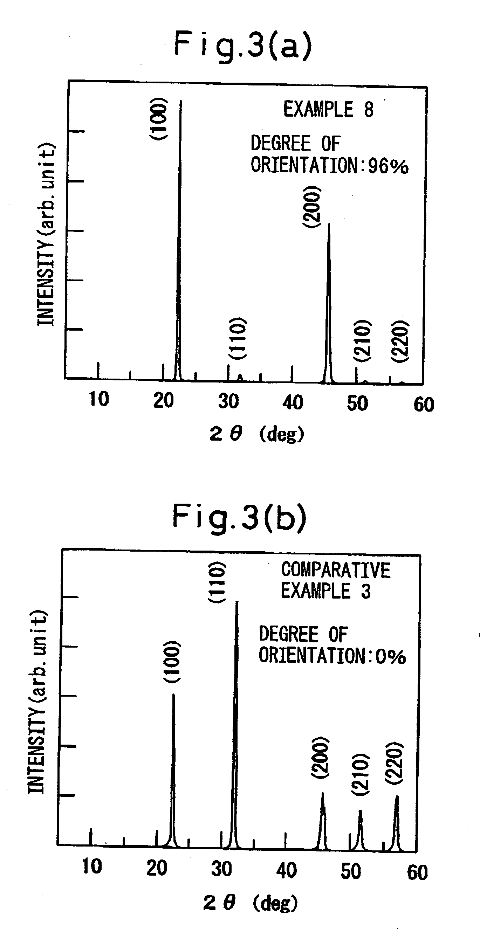

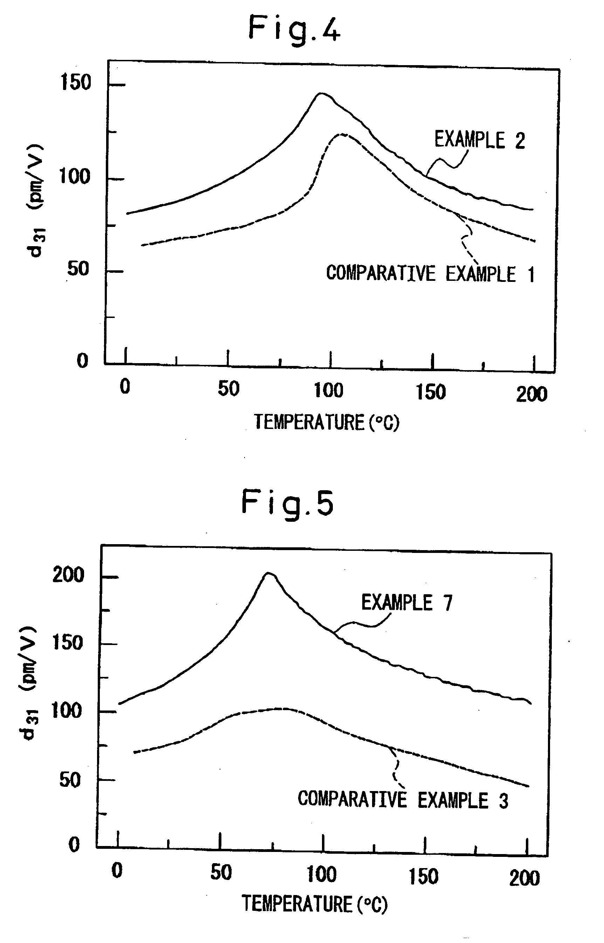

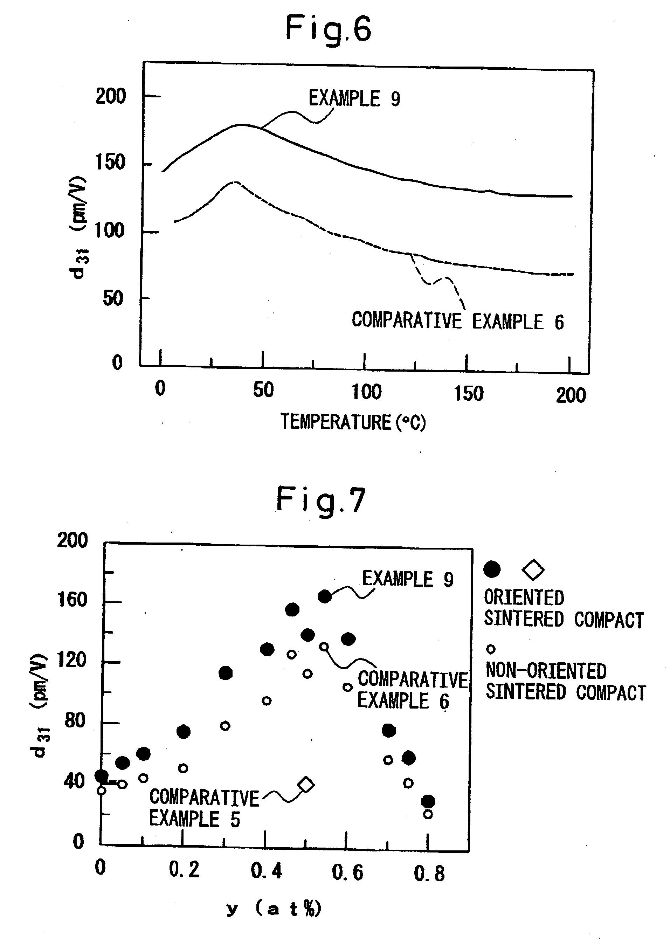

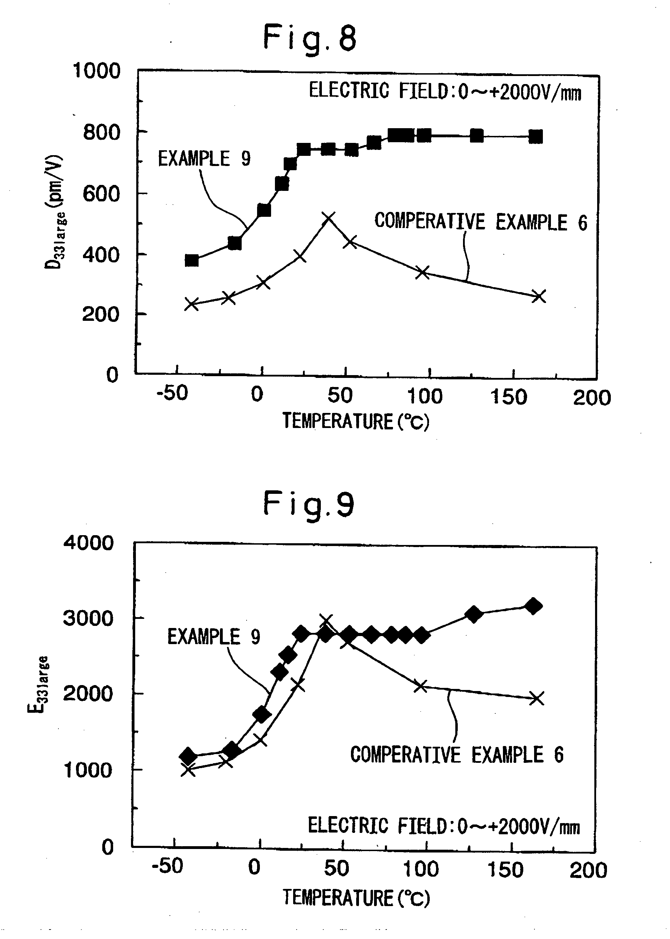

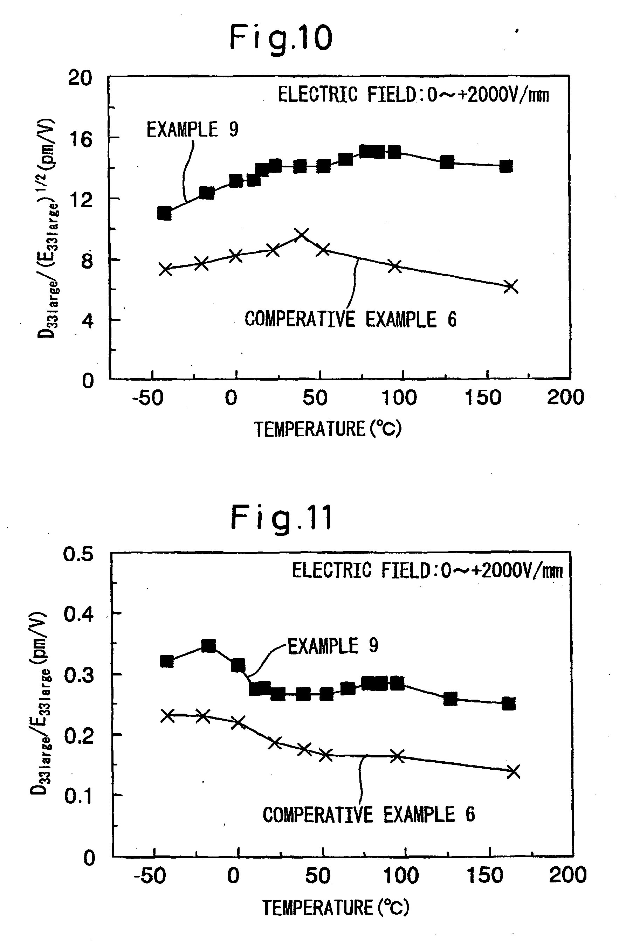

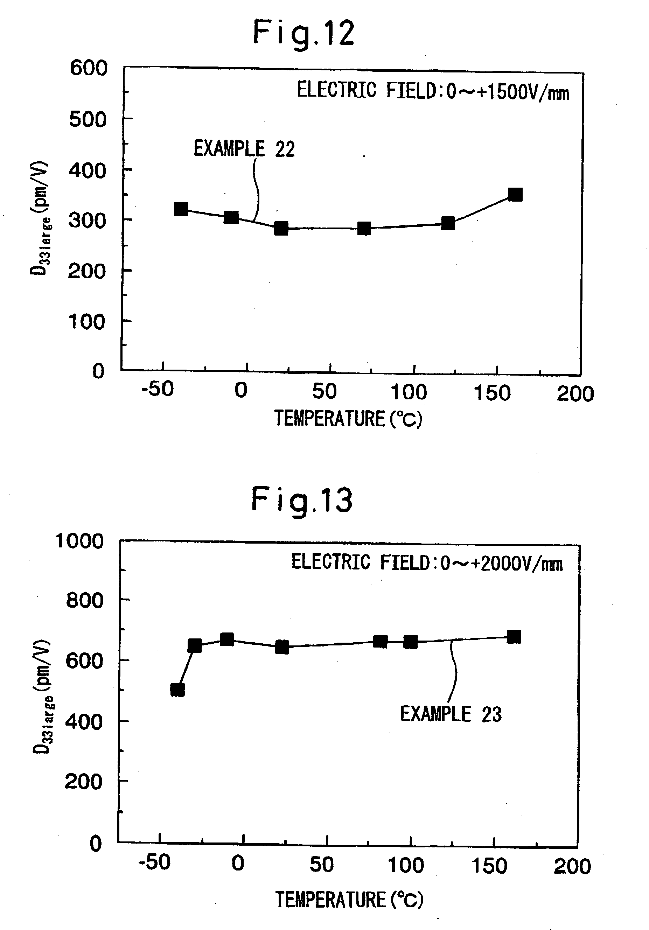

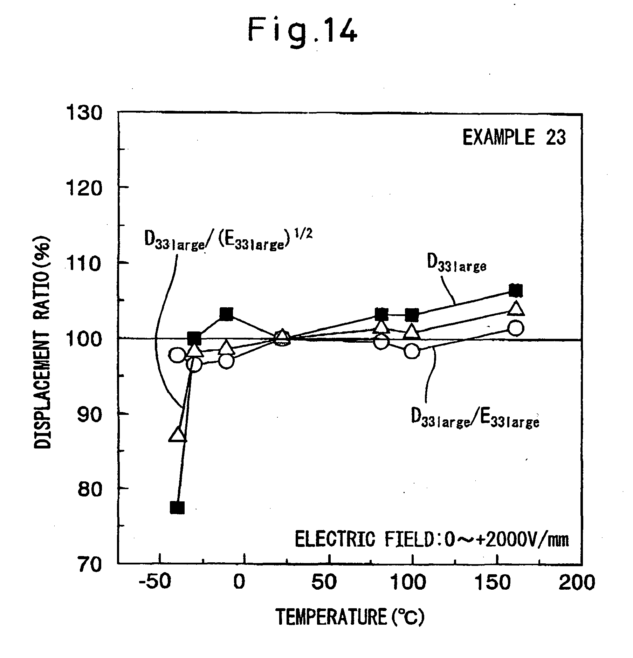

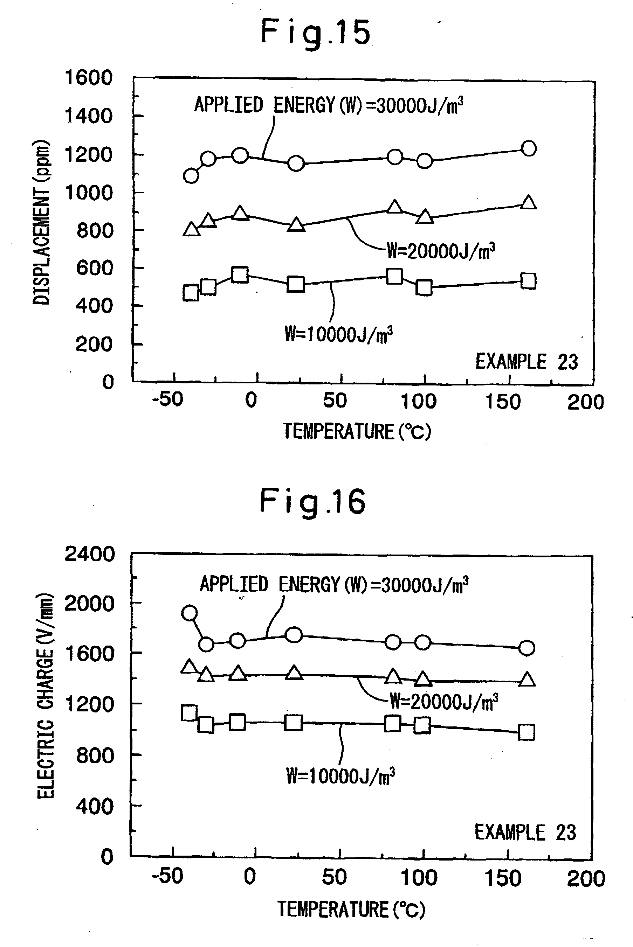

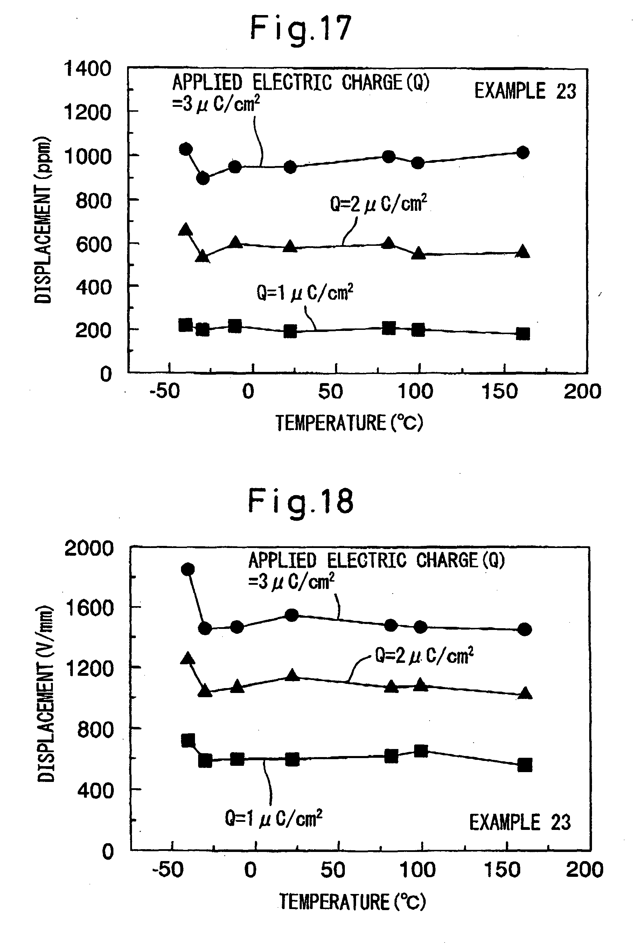

Fig. 1 is an x-ray diffraction pattern of crystal oriented ceramics obtained in Example 1. Fig. 2 is an X-ray diffraction pattern of crystal oriented ceramics obtained in Example 3. Figs. 3(a) and 3(b) are X-ray diffraction patterns of crystal oriented ceramics obtained in Example 8 and a non-oriented sintered compact obtained in Comparative Example 3, respectively. Fig. 4 is a graph showing the temperature dependency of the piezoelectric $d_{31}$ constant of crystal oriented ceramics obtained in Example 2 and a non-oriented sintered compact obtained in Comparative Example 1. Fig. 5 is a graph showing the temperature dependency of the piezoelectric $d_{31}$ constant of crystal oriented ceramics obtained in Example 7 and a non-oriented sintered compact obtained in Comparative Example 3. Fig. 6 is a graph showing the temperature dependency of the piezoelectric $d_{31}$ constant of crystal oriented ceramics obtained in Example 9 and a non-oriented sintered compact obtained in Comparative Example 6. Fig. 7 is a graph showing the temperature dependency of the piezoelectric $d_{31}$ constant at room temperature. Figs. 8 and 9 respectively indicate $D_{33large}$ and $E_{33large}$ in the case of driving by applying an electric field strength of 0-2000 V/mm in the form of a chopping wave having a frequency of 1 Hz over a temperature range of -42 to 165°C to the crystal oriented ceramics obtained in Example 9 and Comparative Example 6 and to the non-oriented sintered compact obtained in Comparative Example 6. Figs. 10 and 11 show the temperature characteristics of $D_{33large}/ (E_{33large})^{1/2}$ and $D_{33large}/E_{33large}$ in the case of driving the crystal oriented ceramics obtained in Example 9 and Comparative Example 6. Fig. 12 shows $D_{33large}$ in the case of producing an actuator with the crystal oriented ceramics obtained in Example 22. Fig. 13 shows $D_{33large}$ in the case of driving the crystal oriented ceramics obtained in Example 23. Fig. 14 shows the results of calculating the temperature characteristics of displacement in the case of constant voltage driving (characteristic index: $D_{33large}$), constant energy driving (characteristic index: $D_{33large}/ (E_{33large})^{1/2}$ and constant charge driving (characteristic index: $D_{33large}/E_{33large}$) using displacement at room temperature as a reference value (100%). Figs. 15 and 16 respectively show the generated displacement and generated electric field in the case of driving the crystal oriented ceramics obtained in Example 23. Figs. 17 and 18 respectively show the generated displacement and generated electric field in the case of driving the crystal oriented ceramics obtained in Example 23.

DESCRIPTION OF THE PREFERRED EMBODIMENTS

The following provides a detailed explanation of one mode for carrying out the present invention. The crystal oriented ceramics according to the present invention is composed of a polycrystalline substance of the isotropic perovskite compound represented by the general formula shown in the following chemical formula 1, and in which a specific crystal plane of each crystal grain that composes the polycrystalline substance is oriented:

$$\{Li_x(K_{1-y}Na_y)_{1-x}\}\{Nb_{1-z-w}Ta_zSb_w\}O_3 \qquad (1)$$

(wherein, $0 \leq x \leq 0.2$, $0 \leq y \leq 1$, $0 \leq z \leq 0.4$, $0 \leq w \leq 0.2$, $x + z + w > 0$).

The crystal oriented ceramics as claimed in the present invention has for its basic composition potassium sodium niobate ($K_{1-y}Na_yNbO_3$), which is a type of isotropic perovskite compound, a portion of the A site element (K, Na) is substituted with a predetermined amount of Li, and/or a portion of the B site element (Nb) is substituted with a predetermined amount of Ta and/or Sb. In chemical formula 1, "x + z + w > 0" indicates that at least one of Li, Ta and Sb should be contained as a substituent.

In addition, in the aforementioned formula (1), "y" represents the ratio of K and Na contained in the crystal oriented ceramics. The crystal oriented ceramics as claimed in the present invention should contain at least one of K or Na as an A site element. Namely, there are no particular restrictions on the ratio y of K and Na, and it may have any arbitrary value from 0 to 1. In order to obtain high piezoelectric characteristics, the value of y is preferably from 0.05 to 0.75, more preferably from 0.20 to 0.70, even more preferably from 0.35 to 0.65, still more preferably from 0.40 to 0.60, and most preferably from 0.42 to 0.60.

The value of "x" represents the substituted amount of Li that is substituted for an A site element in the form of K and/or Na. If a portion of K and/or Na is substituted with Li, effects are obtained in which piezoelectric characteristics improve, Curie temperature rises and/or increased fineness is promoted. More specifically, the value of x is preferably from 0 to 0.2. If the value of x exceeds 0.2, piezoelectric characteristics (including piezoelectric $d_{31}$ constant, electro-mechanical coupling coefficient $k_p$ and piezoelectric $g_{31}$ constant) decrease, thereby making this undesirable. The value of x is preferably from 0 to 0.15, and more preferably from 0 to 0.10.

The value of "z" represents the substituted amount of Ta substituted for the B site element in the form of Nb. If a portion of Nb is substituted with Ta, the effect of improved piezoelectric characteristics is obtained. More specifically, the value of z is preferably from 0 to 0.4. If the value of z exceeds 0.4, the Curie temperature decreases and it becomes difficult to use as a piezoelectric material in home appliance or automotive applications, thereby making this undesirable. The value of z is preferably from 0 to 0.35, and more preferably from 0 to 0.30.

Moreover, the value of "w" represents the substituted amount of Sb substituted for the B site element in the form of Nb. If a portion of Nb is substituted with Sb, the effect of improved piezoelectric characteristics is obtained. More specifically, the value of w is preferably from 0 to 0.2. If the value of w exceeds 0.2, piezoelectric characteristics and/or Curie temperature decrease, thereby making this undesirable. The value of w is preferably from 0 to 0.15, and more preferably from 0 to 0.10.

Furthermore, although it is preferable that the crystal oriented ceramics as claimed in the present invention is composed only of the isotropic perovskite compound represented by the general formula shown in chemical formula 1 (to be referred to as the "first KNN compound"), other elements or other phases may be contained provided the crystal structure of the isotropic perovskite can be maintained, and they do not have detrimental effects on sintering characteristics, piezoelectric characteristics or other characteristics.

Specific examples of such "other elements" include other monovalent cationic elements substituted for an A site element of the first KNN compound (such as $Ag^+$ or $Cs^+$), and other pentavalent cationic elements substituted for a B site element of the first KNN compound (such as $V^{5+}$ or $Re^{5+}$).

In addition, an "other element" substituted for an A site element or B site element may be a combination in which the sum of their valencies is hexavalent. Specific examples include the combination of $Ba^{2+}$ and $Ti^{4+}$, the combination of $Sr^{2+}$ and $Ti^{4+}$, and the combination of $Ca^{2+}$ and $Ti^{4+}$. In addition, an "other element" substituted for a B site element may contain only a hexavalent metal element (such as $W^{6+}$ or $Mo^{6+}$). In this case, a defect is formed at the A site so that the valency of the cationic element becomes hexavalent.

In addition, specific examples of "other phases" include additives, sintering assistants, byproducts and impurities (such as $Bi_2O_3$, $CuO$, $MnO_2$ and $NiO$) originating in the production method described later or the starting materials used. The content of other elements or other phases for which there is the risk of having a detrimental effect on piezoelectric characteristics should be as low as possible.

The phrase "specific crystal plane is oriented" refers to each crystal grain being arranged so that specific crystal planes of the first KNN compound are mutually parallel (this state is to be referred to as "planar orientation"), or to each crystal grain being arranged so that specific crystal planes are parallel to a single axis that passes through the molded product (this state is to be referred to as "axial orientation").

There are no particular restrictions on the type of oriented crystal plane, and is selected according to the direction of spontaneous polarization of the first KNN compound, application of the crystal oriented ceramics, its required characteristics and so forth. Namely, the oriented crystal plane is selected according to the specific purpose, such as the pseudo-cubic {100} plane, pseudo-cubic {110} plane or pseudo-cubic {111} plane.

Furthermore, "pseudo-cubic {HKL}" refers to indication of the Miller indices by assuming the isotropic perovskite compound to be cubic, even though isotropic perovskite compounds typically take on a structure that is slightly strained from a cubic system, such as a tetragonal system, rhombohedral system or trigonal system, since this strain is very small.

In addition, in the case a specific crystal plane is planar oriented, the degree of planar orientation can be represented with the average degree of orientation F(HKL) given by the Lotgering method expressed by the following equation.

$$F(HKL) = \frac{\dfrac{\Sigma' I(HKL)}{\Sigma I(hkl)} - \dfrac{\Sigma' I_0(HKL)}{\Sigma I_0(hkl)}}{1 - \dfrac{\Sigma' I_0(HKL)}{\Sigma I_0(hkl)}} \times 100 \ (\%)$$

Furthermore, in this Equation 1, $\Sigma I(hkl)$ is the sum of the X-ray diffraction intensity of all crystal planes (hkl) measured for crystal oriented ceramics, while $\Sigma I_0(hk1)$ is the sum of the X-ray diffraction intensity of all crystal planes (hkl) measured for non-oriented ceramics having the same composition as the crystal oriented ceramics. In addition, $\Sigma' I(HKL)$ is the sum of the X-ray diffraction intensities of crystallographically equivalent specific crystal planes (HKL) measured for crystal oriented ceramics, while $\Sigma' I_0(HKL)$ is the sum of the x-ray diffraction intensities of crystallographically equivalent specific crystal planes (HKL) measured for non-oriented ceramics having the same composition as the crystal oriented ceramics.

Thus, in the case each crystal grain that composes a polycrystalline substance is non-oriented, the average degree of orientation F(HKL) becomes 0%. In addition, in the case the (HKL) planes of all crystal grains that compose a polycrystalline substance are oriented parallel to a measured plane, the average degree of orientation F(HKL) becomes 100%.

In general, the larger the ratio of oriented crystal grains the higher the characteristics. For example, in the case a specific crystal plane is planar oriented, in order to obtain high piezoelectric characteristics, the average degree of orientation F(HKL) as determined according to the Lotgering method represented by the aforementioned Equation 1 is preferably 30% or more, and more preferably 50% or more. In addition, an oriented specific crystal plane is preferably a plane that is perpendicular to the polarization axis. For example, in the case the crystal system of the perovskite compound is a tetragonal system, the specific crystal plane to be oriented is preferably the {100} plane.

Furthermore, in the case of axially orienting a specific crystal plane, the degree of its orientation cannot be defined by the same degree of orientation as in the case of planar orientation (Equation 1). However, the degree of axial orientation can be represented using the average degree of orientation according to the Lotgering method with respect to (HKL) diffraction in the case of x-ray diffraction for a plane perpendicular to the orientation axis (to be referred to as the "degree of axial orientation"). In addition, the degree of axial orientation of a molded product in which a specific crystal plane is nearly completely axial oriented is equal to the degree of axial orientation measured for a molded product in which a specific crystal plane is nearly completely planar oriented.

Since the crystal oriented ceramics as claimed in the present invention is composed of a polycrystalline substance having the first KNN compound as its primary phase, it exhibits high piezoelectric characteristics even among lead-free-based piezoelectric ceramics. In addition, since the specific crystal plane of each crystal grain that composes the polycrystalline substance is oriented in a single direction, the crystal oriented ceramics as claimed in the present invention exhibits high piezoelectric characteristics as compared with a non-oriented sintered compact having the same composition.

More specifically, by optimizing the composition, degree of orientation, production conditions and so forth of the first KNN compound serving as the primary phase, crystal oriented ceramics is obtained in which the piezoelectric $d_{31}$ constant at room temperature is at least 1.1 times greater than a non-oriented sintered compact having the same composition. In addition, if these conditions are optimized, crystal oriented ceramics can be obtained in which the piezoelectric $d_{31}$ constant at room temperature is 1.2 times or more greater than a non-oriented sintered compact having the same composition, or 1.3 times or more greater if further optimized.

Similarly, by optimizing the composition, degree of orientation, production conditions and so forth of the first KNN compound serving as the primary phase, crystal oriented ceramics can be obtained in which the electromechanical coupling coefficient $k_p$ at room temperature is at least 1.1 times greater than a non-oriented sintered compact having the same composition. In addition, if these conditions are optimized, crystal oriented ceramics can be obtained in which the electromechanical coupling coefficient $k_p$ at room temperature can be made to be 1.2 times or more greater than a non-oriented sintered compact having the same composition, or 1.3 times or more greater if further optimized.

Moreover, by optimizing the composition, degree of orientation, production conditions and so forth of the first KNN compound serving as the primary phase, crystal oriented ceramics can be obtained in which the piezoelectric $g_{31}$ constant at room temperature is at least 1.1 times greater than a non-oriented sintered compact having the same composition. In addition, if these conditions are optimized, crystal oriented ceramics can be obtained in which the piezoelectric $g_{31}$ constant at room temperature is 1.2 times or more greater than a non-oriented sintered compact having the same composition, or 1.4 times or more greater if further optimized.

In addition, in the case of an actuator material, displacement generated in the direction parallel to the direction in which voltage is applied is utilized in a large electric field having an electric field strength of 100 v/mm or more. By optimizing the composition, degree of orientation, production conditions and so forth of the first KNN compound that serves as its primary phase, crystal oriented ceramics are obtained in which the displacement generated in a large electric field under the same temperature and electric field strength conditions is at least 1.1 times greater than a non-oriented sintered compact having the same composition. In addition, crystal oriented ceramics are obtained in which the aforementioned displacement is at least 1.2 times that of a non-oriented sintered compact having the same composition if these conditions are optimized, and that in which the aforementioned displacement is at least 1.3 times that of a non-oriented sintered compact are obtained if these conditions are optimized further. In addition, in an actuator material, it is preferable that the temperature dependency of the displacement generated in a large electric field is small. Non-oriented sintered compacts have large temperature dependency of the generated displacement, thereby making them unsuitable for use in actuator applications. However, by optimizing the composition, degree of orientation, production conditions and so forth of the first KNN compound serving as the primary phase, crystal oriented ceramics are obtained having superior temperature characteristics in which the amount of fluctuation from the average value of the maximum value and minimum value of the displacement generated in a large electric field is within at least $\pm 20\%$ over an arbitrary temperature range of 100°C or more. Moreover, crystal oriented ceramics are obtained in which the amount of fluctuation from the average value of the maximum displacement and the minimum displacement over an arbitrary temperature range of 100°C or more is within at least $\pm 10\%$ if these conditions are further optimized, within at least $\pm 7\%$ if these conditions are even further optimized, and within at least $\pm 5\%$ if these conditions are optimized even more. Furthermore, in order to increase displacement, the electric field strength during driving is preferably 500 V/mm or more, and more preferably 1000 V/mm or more.

Moreover, methods for controlling the displacement generated in a large electric field can be classified into: (1) a voltage control method in which the voltage is controlled as a parameter, (2) an energy control method in which displacement is controlled by using injection energy as a parameter, and (3) a charge control method in which displacement is controlled by using injection charge as a parameter. In the case of the voltage control method of (1), the temperature dependency of the displacement generated at a constant voltage is preferably small. In the case of the energy control method of (2), the temperature dependency of the displacement generated at a constant injection energy is preferably small. In the case of the charge control method of (3), the temperature dependency of the displacement generated at a constant injection charge is preferably small.

In addition, in the case of energy control and charge control, since the terminal voltage applied to the actuator and drive circuit fluctuates according to the temperature dependency of the electrostatic capacitance in a large electric field, it is necessary to design the circuit at the upper limit of the amount of fluctuation of the terminal voltage. Since expensive circuit elements having a high withstand voltage may be required depending on the temperature characteristics of the electrostatic capacitance, the temperature characteristics of the electrostatic capacitance are preferably small. These findings can be easily understood from equations A3 and A4.

$$W = 1/2 \times C \times V^2 \qquad\qquad A3$$

$$Q = C \times V \qquad\qquad A4$$

Here, w represents energy (J), C electrostatic capacitance (F), V applied voltage (V) and Q charge (C).

In addition, since actuator displacement (electric field induced displacement: $\Delta L$) is in a proportional relationship with applied voltage, the displacement during constant electric field driving (EF: constant) is proportional to $D_{33large}$ according to equation A5.

$$\Delta L = D_{33large} \times EF_{max} \times L \qquad\qquad A5$$

Here, $D_{33large}$ represents dynamic strain (m/V), $EF_{max}$ maximum electric field strength (V/m) and L original length before application of voltage (m). $D_{33large}$ was determined according to equation A6 as the dynamic strain of displacement generated in a direction parallel to the direction in which voltage is applied in the case of driving by applying a high voltage having an electric field strength of 0-2000 V/mm at a constant amplitude.

$$D_{33large} = S_{max}/EF_{max} = (\Delta L/L)/(V/L) \qquad A6$$

Here, $S_{max}$ represents the maximum strain.

In addition, displacement ($\Delta L$) during constant energy driving (W: constant) is proportional to $D_{33large}/(E_{33large})^{1/2}$ from equations A7 and A8.

$$\Delta L = D_{33large} \times (2 \times W/C)^{1/2} \qquad A7$$

$$C = E_{33large} \times \varepsilon_0 \times A/L \qquad A8$$

Here, $\Delta L$ represents the amount of displacement induced by the electric field (m), $E_{33large}$ the dynamic dielectric constant, A the electrode surface area ($m^2$) and $\varepsilon_0$ the dielectric constant in a vacuum (F/m).

Furthermore, $E_{33large}$ was calculated according to equation A9 by measuring the amount of polarization from a polarization-electric field hysteresis loop in the case of driving by applying a high voltage having an electric field strength of 0-2000 V/mm at a constant amplitude, and using the amount of injection charge during driving in the high electric field as the dielectric constant (dynamic dielectric constant) based on this.

$$E_{33large} = P_{max}/(EF_{max} \times \varepsilon_0) = (Q_{max}/A)/(V/L) \times \varepsilon_0) \qquad A9$$

Here, $P_{max}$ represents the maximum charge density ($C/m^2$), and $Q_{max}$ represents the maximum charge (C).

Moreover, the displacement (electric field induced displacement: $\Delta L$) during constant charge driving (Q: constant) is proportional to $D_{33large}/E_{33large}$ according to equations A10 and A8.

$$\Delta L = D_{33large} \times Q/C \qquad A10$$

In non-oriented sintered compacts, the temperature dependencies of $D_{33large}$ and $E_{33large}$ are large, and since the temperature dependencies of $D_{33large}/(E_{33large})^{1/2}$ and $D_{33large}/E_{33large}$ are also large, they are not suitable for actuator applications. However, by optimizing the composition, degree of orientation, production conditions and so forth of the first KNN compound that serves as the primary phase, crystal oriented ceramics having superior temperature characteristics are obtained in which any one of the amounts of fluctuation from the average value of the maximum and minimum values of $D_{33large}/(E_{33large})^{1/2}$, $D_{33large}/E_{33large}$ or $E_{33large}$ generated in a large electric field is at least within $\pm 20\%$ over an arbitrary temperature range of 100°C or more. Moreover, crystal oriented ceramics are obtained in which the amount of fluctuation from the average value of the maximum and minimum values of $D_{33large}/(E_{33large})^{1/2}$, $D_{33large}/E_{33large}$ or $E_{33large}$ over an arbitrary temperature range of 100°C or more is at least within $\pm 15\%$ if these conditions are optimized, within $\pm 10\%$ if they are further optimized, within $\pm 8\%$ if they are even further optimized, and within $\pm 5\%$ if they are optimized even more.

Next, an explanation is provided of the first anisotropic shaped powder used in the production of the crystal oriented ceramics as claimed in the present invention. Ceramics having a complex composition in the manner of the first KNN compound are normally produced by mixing simple compounds containing constituent elements to their stoichiometric ratios, molding and calcing this mixture followed by crushing and finally remolding and sintering of the crushed powder. However, in the case of such a method, it is extremely difficult to obtain an oriented sintered compact in which a specific crystal plane of each crystal grain is oriented in a specific direction. In order to solve this problem, the present invention orients a first anisotropic shaped powder that satisfies specific conditions in a molded product, and then synthesizes and sinters a first KNN compound using the first anisotropic shaped powder as a template or reactive template to orient a specific crystal plane of each crystal grain that composes the polycrystalline substance in a single direction. In the present invention, a first anisotropic shaped powder is used that satisfies the following conditions.

First, a first anisotropic shaped powder is used that has a shape that facilitates orientation in a fixed direction during molding. Consequently, the average aspect ratio (i.e., the average of the maximum dimension of the first anisotropic shaped powder divided by the minimum dimension) of the first anisotropic shaped powder is preferably 3 or more. If the average aspect ratio is less than 3, it becomes difficult to orient the first anisotropic shaped powder in a single direction during molding, thereby making this undesirable. In order to obtain crystal oriented ceramics having a high degree of orientation, the average aspect ratio of the first anisotropic shaped powder is preferably 5 or more, and more preferably 10 or more.

In general, orienting the first anisotropic shaped powder during molding tends to become easier the larger the average aspect ratio of the first anisotropic shaped powder. However, if the average aspect ratio becomes excessively large, the first anisotropic shaped powder may be crushed in the mixing step to be described later, thereby preventing the obtaining of a molded product in which the first anisotropic shaped powder is oriented. Thus, the average aspect ratio of the first anisotropic shaped powder is preferably 100 or less.

In addition, the average particle diameter of the first anisotropic shaped powder (average value of the dimension in the lengthwise direction) is preferably 0.05 $\mu$m or more. If the average particle diameter of the first anisotropic shaped powder is less than 0.05 $\mu$m, it becomes difficult to orient the first anisotropic shaped particle in a fixed direction due to the shear stress that acts during molding. In addition, since the gain in interface energy is low, epitaxial growth into template particles becomes difficult when using the first anisotropic shaped powder as a reactive template when producing crystal oriented ceramics.

On the other hand, the average particle diameter of the first anisotropic shaped powder is preferably 20 $\mu$m or less. If the average particle diameter of the first anisotropic shaped powder exceeds 20 $\mu$m, sintering properties decrease thereby preventing the obtaining of crystal oriented ceramics having a high sintered compact density. The average particle diameter of the first anisotropic shaped powder is more preferably 0.1 to 10 $\mu$m.

Secondly, a powder in which the growth plane (plane that occupies the largest surface area) has lattice coherency with a specific crystal plane of the first KNN compound is used for the first anisotropic shaped powder. Even in the case of an anisotropic shaped powder having a predetermined shape, if its growth plane does not have lattice coherency with a specific crystal plane of the first KNN compound, it may not function as a reactive template for producing the crystal oriented ceramics as claimed in the present invention, thereby making this undesirable.

The degree of lattice coherency can be represented by the value obtained by dividing the absolute value of the difference between the lattice dimensions of the growth plane of the first anisotropic shaped powder and the lattice dimensions of a specific crystal plane of the first KNN compound by the lattice dimensions of the growth plane of the first anisotropic shaped powder (and this value is referred to as the "lattice coherency rate"). This lattice coherency rate may differ slightly depending on the direction taken by the lattice. In general, the first anisotropic shaped powder functions better as a template the smaller the average lattice coherency rate (average value of the lattice coherency rates calculated for each direction. In order to obtain crystal oriented ceramics having a high degree of orientation, the average lattice coherency rate of the first anisotropic shaped powder is preferably 20% or less, and more preferably 10% or less.

Thirdly, the first anisotropic shaped powder is not necessarily required to have the same composition as the first KNN compound, but rather may be that which forms a first KNN compound having a target composition by reacting with a first reaction raw material to be described later. Thus, the first anisotropic shaped powder is selected from among a compound or solid solution that contains one or more types of any of the cationic elements contained in the first KNN compound to be produced.

Furthermore, "anisotropic shape" refers to the dimension in the lengthwise direction being large in comparison with the dimension in the direction of width or thickness. More specifically, preferable examples of anisotropic shapes include plates, columns and scales. In addition, there are no particular restrictions on the type of crystal plane that composes the growth plane, and it may be selected from various crystal planes according to the objective.

In the case of a first anisotropic shaped powder that satisfies the aforementioned conditions, it functions as a template or reactive template for producing the crystal oriented ceramics as claimed in the present invention. The following provides specific examples of materials that satisfy these conditions.

Preferable first specific examples of the material of the first anisotropic shaped powder include the isotropic perovskite compounds of $NaNbO_3$ (to be referred to as "NN"), $KNbO_3$ (to be referred to as "KN") and $K_{1-y}Na_yNbO_3$ or those in which a predetermined amount of Li, Ta and/or Sb is substituted or put into solid solution, and which are represented by the general formula shown below (to be collectively referred to as the "second KNN compound"):

$$\{Li_x(K_{1-y}Na_y)_{1-x}\}\{Nb_{1-z-w}Ta_zSb_w\}O_3 \qquad (2)$$

(wherein, x, y, z and w are respectively $0 \leq x \leq 1$, $0 \leq y \leq 1$, $0 \leq z \leq 1$, $0 \leq w \leq 1$).

The second KNN compound naturally has satisfactory lattice coherency with the first KNN compound. Consequently, a first anisotropic shaped powder composed of the second KNN compound and having a specific crystal plane for its growth plane (to be specifically referred to as "anisotropic shaped powder A") functions a reactive template for producing the crystal oriented ceramics as claimed in the present invention. In addition, since anisotropic shaped powder A is substantially composed from cationic elements contained in the first KNN compound, crystal oriented ceramics can be produced having an extremely low level of impurity elements. Among these, a plate-like powder composed of the second KNN compound having a pseudo-cubic {100} plane for the growth plane is preferable as a reactive template for producing the crystal oriented ceramics as claimed in the present invention, while NN or KN plate-like powder having a pseudo-cubic {100} plane for the growth plane is particularly preferable.

A preferable second specific example of a raw material of the first anisotropic shaped powder is a powder composed of a layered perovskite compound and in which a crystal plane having a low level of surface energy has lattice coherency with a specific crystal plane of the first KNN compound. Since layered perovskite compounds have large anisotropy of the crystal lattice, an anisotropic shaped powder having for its growth plane a crystal plane having a low level of surface energy (to be specifically referred to as the "second anisotropic shaped powder") can be synthesized comparatively easily.

A first specific example of a layered perovskite composite that is preferable as the raw material of the second anisotropic shaped powder is the bismuth layered perovskite composite represented by the following general formula:

$$(Bi_2O_2)^{2+}(Bi_{0.5}AM_{m-1}Nb_mO_{3m+1})^{2-} \qquad (3)$$

(wherein, m represents an integer of 2 or more, and AM represents at least one alkaline metal element selected from Li, K and Na).

Since the surface energy of the {001} plane is smaller than the surface energy of other crystal planes in the compound represented by formula (3), a second anisotropic shaped powder having the {001} plane for the growth plane can be synthesized easily. Here, the {001} plane refers to the plane parallel to the $(Bi_2O_2)^{2-}$ layer of the bismuth layered perovskite composite represented by formula (3). Moreover, the {001} plane of the compound represented by formula (3) has extremely satisfactory lattice coherency with the pseudo-cubic {100} plane of the first KNN compound.

consequently, the second anisotropic shaped powder composed of the compound represented by formula (3) and having the {001} plane for its growth plane is preferable as a reactive template for producing crystal oriented ceramics having the pseudo-cubic {100} plane for its growth plane. In addition, if the compound represented by formula (2) is used, crystal oriented ceramics can be produced having for its primary phase a first KNN compound substantially free of Bi as an A site element by optimizing the composition of the first reaction raw material to be described later.

A second specific example of a layered perovskite compound preferable for use as a raw material of the second anisotropic shaped powder is $Sr_2Nb_2O_7$. The surface energy of the {010} plane of $Sr_2Nb_2O_7$ is lower than that of other crystal planes, and it has extremely satisfactory lattice coherency with the pseudo-cubic {110} plane of the first KNN compound. Consequently, an anisotropic shaped powder composed of $Sr_2Nb_2O_7$ and having the {010} plane for its growth plane is preferable as a reactive template for producing crystal oriented ceramics having the {110} plane for its growth plane.

A third example of a layered perovskite compound preferable for use as a raw material of the second anisotropic shaped powder includes $Na_{1.5}Bi_{2.5}Nb_3O_{12}$, $Na_{2.5}Bi_{2.5}Nb_4O_{15}$, $Bi_3TiNbO_9$, $Bi_3TiTaO_9$, $K_{0.5}Bi_{2.5}Nb_2O_9$, $CaBi_2Nb_2O_9$, $SrBi_2Nb_2O_9$, $BaBi_2Nb_2O_9$, $BaBi_3Ti_2NbO_{12}$, $CaBi_2Ta_2O_9$, $SrBi_2Ta_2O_9$, $BaBi_2Ta_2O_9$, $Na_{0.5}Bi_{2.5}Ta_2O_9$, $Bi_7Ti_4NbO_{21}$ and $Bi_5Nb_3O_{15}$. The {001} planes of these compounds have satisfactory lattice coherency with the pseudo-cubic {100} plane of the first KNN compound. Consequently, anisotropic shaped powder composed of these compounds and which has the {001} plane for its growth plane is preferable as a reactive template for producing crystal oriented ceramics having the pseudo-cubic {100} plane for the growth plane.

A fourth specific example of a layered perovskite compound preferable for use as a raw material of the second anisotropic shaped powder includes $Ca_2Nb_2O_7$ and $Sr_2Ta_2O_7$. The {010} planes of these compounds have satisfactory lattice coherency with the pseudo-cubic {110} plane of the first KNN compound. Consequently, anisotropic shaped powder composed of these compounds and which has the {010} plane for its growth plane is preferable as a reactive template for producing crystal oriented ceramics having the pseudo-cubic {110} plane for the growth plane.

Next, an explanation is provided of a method for producing the first anisotropic shaped powder. A first anisotropic shaped powder composed of a layered perovskite composite provided with a predetermined composition, average particle diameter and/or aspect ratio (namely, a second anisotropic shaped powder) can be easily produced by heating a raw material such as an oxide, carbonate or nitrate containing a constituent element of the second anisotropic shaped powder (to be referred to as the "anisotropic shaped powder forming raw material") with a liquid or substance that becomes a liquid as a result of heating.

If the anisotropic shaped powder forming raw material is heated in a liquid phase that facilitates diffusion of atoms, a second anisotropic shaped powder can be easily synthesized in which a plane having a low level of surface energy (for example, the {001} plane in the case of the substance represented by formula (3)) has grown preferentially. In this case, the average aspect ratio and average particle diameter of the second anisotropic shaped powder can be controlled by suitably selecting the synthesis conditions.

Specific preferable examples of a method for producing the second anisotropic shaped powder include a method in which a suitable flux (such as NaCl, KCl, mixture of NaCl and KCl, $BaCl_2$ or KF) is added to the anisotropic shaped powder forming raw material followed by heating at a predetermined temperature (flux method), and a method in which an irregularly shaped powder having a composition identical to the second anisotropic shaped powder to be produced is heated in an autoclave with an aqueous alkaline solution (aqueous heating synthesis method).

On the other hand, since the anisotropy of the crystal lattice is extremely small in the second KNN compound, it is difficult to synthesize directly a first anisotropic shaped powder composed of a second KNN solid solution and which has a specific crystal plane for its growth plane (namely, anisotropic shaped powder A). However, anisotropic shaped powder A can be produced by heating with a second reaction raw material that satisfies predetermined conditions in a flux using the aforementioned second anisotropic shaped powder as a reactive template.

Furthermore, in the case of synthesizing anisotropic shaped powder A using the second anisotropic shaped powder as a reactive template, optimization of the reaction conditions makes it possible to cause changes to occur only in the crystal structure without causing hardly any changes in the powder shape. In addition, although the average particle diameter and/or aspect ratio of the second anisotropic shaped powder are normally kept the same before and after reaction, if the reaction conditions are optimized, the average particle diameter and/or aspect ratio of the resulting anisotropic shaped powder A can be increased or decreased.

However, in order to synthesize an anisotropic shaped powder A that can easily be oriented in a single direction during molding, the second anisotropic shaped powder used during that synthesis also preferably has a shape that facilitates orientation in a single direction during molding.

Namely, in the case of synthesizing anisotropic shaped powder A using the second anisotropic shaped powder as a reactive template as well, the average aspect ratio of the second anisotropic shaped powder is preferably at least 3 or more, more preferably 5 or more, and even more preferably 10 or more. In addition, in order to suppress crushing in the following steps, the average aspect ratio is preferably 100 or less. Moreover, the average particle diameter of the second anisotropic shaped powder is preferably 0.05 to 20 $\mu$m, and more preferably 0.1 to 10 $\mu$m.

The "second reaction raw material" refers to that which at least forms anisotropic shaped powder A composed of the second KNN compound by reacting with the aforementioned second anisotropic shaped powder. In this case, the second reaction raw material may form only the second KNN compound by reacting with the second anisotropic shaped powder, or it may form both the second KNN compound and a superfluous component. Here, the "superfluous component" refers to a substance other than the target second KNN compound. In addition, in the case a superfluous component is formed by the second anisotropic shaped powder and second reaction raw material, the superfluous component is preferably composed of that which is easily removed either thermally or chemically.

There are no particular restrictions on the shape of the second reaction raw material, and an oxide powder, compound oxide powder, carbonate, nitrate or oxalate salt or alkoxide, for example, can be used. In addition, the composition of the second reaction raw material is determined according to the composition of the second KNN compound to be produced and the composition of the second anisotropic shaped powder.

For example, in the case of synthesizing an anisotropic shaped powder A composed of NN, which is a type of second KNN compound, using a second anisotropic shaped powder composed of $Bi_{2.5}Na_{0.5}Nb_2O_9$, which is a type of bismuth layered perovskite composite represented by formula (3) (to be referred to as "BINN2"), a compound containing Na (oxide, hydroxide, carbonate, nitrate and so forth) should be used for the second reaction raw material. In this case, an Na-containing compound equivalent to 1.5 mol of Na atoms to 1 mol of BINN2 should be added as the second reaction raw material.

When 1 wt% to 500 wt% of a suitable flux (for example, NaCl, KCl, mixture of NaCl and KCl, $BaCl_2$ or KF) is added to a second anisotropic shaped powder and second reaction raw material having the aforementioned compositions followed by heating to the eutectic point or melting point, a superfluous component consisting primarily of NN and $Bi_2O_3$ is formed. Since $Bi_2O_3$ has a low melting point and is also susceptible to acid, after removing the flux from the resulting reaction product by washing with hot water and so forth, it is then either heated at a high temperature or washed with acid to obtain an anisotropic shaped powder composed of NN having the {100} plane for the growth plane.

In addition, in the case of, for example, synthesizing an anisotropic shaped powder A composed of $K_{0.5}Na_{0.5}NbO_3$, which is a type of second KNN solid solution (to be referred to as "KNN") using a second anisotropic shaped powder composed of BINN2, a compound containing Na (such as an oxide, hydroxide, carbonate or nitrate) and a compound containing K (such as an oxide, hydroxide, carbonate or nitrate), or a compound containing both Na and K, should be used for the second reaction raw material. In this case, an Na-containing compound equivalent to 0.5 mol of Na atoms and a K-containing compound equivalent to 1 mol of K atoms, with respect to 1 mol of BINN2, should be added as the second reaction raw material.

When 1 wt% to 500 wt% of a suitable flux is added to a second anisotropic shaped powder and a second reaction raw material having the aforementioned compositions followed by heating to the eutectic point or melting point, since a superfluous component is formed consisting primarily of KNN and $Bi_2O_3$, if the flux and $Bi_2O_3$ are removed from the resulting reaction product, an anisotropic shaped powder A is obtained composed of KNN and which has the {100} plane for its growth plane.

This applies similarly to the case of forming only the second KNN compound by reacting the second anisotropic shaped powder and the second reaction raw material, in that a second anisotropic shaped powder having a predetermined composition and a second reaction raw material having a predetermined composition should be heated in a suitable flux. As a result, a second KNN compound having the target composition is formed in the flux. In addition, if the flux is removed from the resulting reaction product, an anisotropic shaped powder A is obtained composed of the second KNN compound and which has a specific crystal plane for its growth plane.

Since the anisotropy of the crystal lattice is small in the second KNN compound, it is difficult to synthesize an anisotropic shaped powder A directly. In addition, it is also difficult to synthesize directly an anisotropic shaped powder A having an arbitrary crystal plane for the growth plane.

In contrast, since the anisotropy of the crystal lattice is large in the case of layered perovskite composites, it is easy to synthesize an anisotropic shaped powder directly from such a compound. In addition, the growth surface of an anisotropic shaped powder composed of a layered perovskite composite frequently has lattice coherency with a specific crystal plane of a second KNN compound. Moreover, second KNN compounds are thermodynamically more stable as compared with layered perovskite composites. Consequently, when a second reaction raw material is reacted in a suitable flux with a second anisotropic shaped powder, which is composed of a layered perovskite composite and in which its growth plane has lattice coherency with a specific growth plane of a second KNN compound, the second anisotropic shaped powder functions as a reactive template, facilitating the synthesis of an anisotropic shaped powder A composed of a second KNN compound that inherits the orientation azimuth of the second anisotropic shaped powder.

In addition, by optimizing the compositions of the second anisotropic shaped powder and the second reaction raw material, A site elements contained in the second anisotropic shaped powder (to be referred to as "superfluous A site elements" are expelled in the form of superfluous components, and an anisotropic shaped powder A is formed that is composed of a second KNN compound free of superfluous A site elements.

In the case the second anisotropic shaped powder is composed of a bismuth layered perovskite composite as shown in formula (3) in particular, Bi is expelled as a superfluous A site element, and a superfluous component is formed composed primarily of $Bi_2O_3$. Consequently, if this superfluous component is removed either thermally or chemically, an anisotropic shaped powder A is obtained composed of a second KNN compound but substantially free of Bi, and having a specific crystal plane for its growth plane.

Next, an explanation is provided of a method for producing crystal oriented ceramics as claimed in the present invention. The crystal oriented ceramics production method as claimed in the present invention is provided with a mixing step, a molding step and a heat treatment step.

First, an explanation is provided of the mixing step. The mixing step consists of mixing a first anisotropic shaped powder and a first reaction raw material. Here, the "first anisotropic shaped powder" refers to that in which the growth plane has lattice coherency with a specific crystal plane of a first KNN compound. Specific examples of powders that can be used for the first anisotropic shaped powder include the previously described anisotropic shaped powder A and the second anisotropic shaped powder.

In addition, the "first reaction raw material" refers to that which at least forms a first KNN compound by reacting with a first anisotropic shaped powder. In this case, the first reaction raw material may form only the first KNN compound by reacting with the first anisotropic shaped powder, or it may form both the second KNN compound and a superfluous component. In addition, in the case a superfluous component is formed by the first anisotropic shaped powder and first reaction raw material, the superfluous component is preferably that which is easily removed either thermally or chemically.

The composition of the first reaction raw material is determined according to the composition of the first anisotropic shaped powder and the first KNN compound to be produced. In addition, there are no particular restrictions on the shape of the first reaction raw material, and an oxide powder, compound oxide powder, carbonate, nitrate or oxalate salt or alkoxide, for example, can be used.

For example, in the case of producing crystal oriented ceramics composed of a first KNN compound using an anisotropic shaped powder A having a KNN or NN composition for the first anisotropic shaped powder, a mixture of compounds containing at least one element selected from Li, K, Na, Nb, Ta and Sb should be used for the first reaction raw material, and these should be blended to have a stoichiometric composition so that a first KNN compound is formed having the target composition from the anisotropic shaped powder A and the first reaction raw material.

In addition, in the case of producing crystal oriented ceramics composed of a first KNN compound by using a second anisotropic shaped powder having the composition represented by formula (3) for the first anisotropic shaped powder, a mixture of compounds containing at least one element selected from Li, K, Na, Nb, Ta and Sb should be used for the first reaction raw material, and these should be blended to have a stoichiometric composition so that a first KNN compound having the target composition and $Bi_2O_3$ are formed from the second anisotropic shaped powder and the first reaction raw material. This applies similarly to cases of producing crystal oriented ceramics having other compositions.

Furthermore, in the mixing step, an irregular fine powder (to be referred to as a "compound fine powder"), composed of a compound having the same composition as the first KNN compound obtained by these reactions, and/or a sintering aid (such as CuO) may be added to the first anisotropic shaped powder and first reaction raw material blended at a predetermined ratio. The addition of a compound fine powder and sintering assistant to the first anisotropic shaped powder and first reaction raw material has the advantage of further facilitating fineness of the sintered compact.

In addition, in the case of blending in a compound fine powder, if the blending ratio of the compound fine powder is excessively large, there is the risk of the degree of orientation of a specific crystal plane decreasing since the blending ratio of the first anisotropic shaped powder inevitably becomes lower. Thus, the blending ratio of the compound fine powder is preferably selected to be the optimum ratio according to the required density and degree of orientation of the sintered compact.

The blending ratio of the first anisotropic shaped powder is preferably made to be such that the ratio of A sites occupying the first KNN compound represented by $ABO_3$ is 0.01-70 at%, more preferably 0.1-50 at%, and even more preferably 1-10 at%, by one or a plurality of constituent elements within the first anisotropic shaped powder.

Moreover, mixing of the first anisotropic shaped powder and first reaction raw material with a compound fine powder and sintering assistant if necessary may be performed by dry mixing or by wet mixing by adding a suitable dispersant such as water or alcohol. Moreover, a binder and/or plasticizer may also be added if necessary at this time.

Next, an explanation is provided of the molding step. In the molding step, the mixture obtained in the mixing step is molded so that the first anisotropic shaped powder is oriented. In this case, the mixture may be molded so that the first anisotropic shaped powder is planar oriented or so that the first anisotropic shaped powder is axially oriented.

There are no particular restrictions on the molding method provided it allows the first anisotropic shaped powder to be oriented. Specific preferred examples of molding method resulting in planar orientation of the method first anisotropic shaped powder include the doctor blade, press molding and rolling methods. In addition, specific preferred examples of molding methods resulting in axial orientation of the first anisotropic shaped powder include extrusion molding and centrifugal molding.

In addition, treatment such as laminated pressing, pressing, rolling may be carried out to increase the thickness of the molded product in which the first anisotropic shaped powder is planar oriented (to be referred to as a "planar oriented molded product") or increase the degree of orientation (to be referred to as "planar orientation treatment"). In this case, one type of any planar orientation treatment or two or more types of such treatment may be carried out on the planar oriented molded product. In addition, a single type of planar orientation treatment may be carried out once or a plurality of times on a planar oriented molded product, or two or more types of planar orientation treatment may be carried out a plurality of times each. Next, an explanation is provided of the heat treatment step. In the heat treatment step, the molded product obtained in the molding step is heated to cause the first anisotropic shaped powder and first reaction raw material to react. When a molded product containing a first anisotropic shaped powder and first reaction raw material is heated to a predetermined temperature, a first KNN compound is formed by these reactions, and simultaneous to its formation, sintering of the first KNN compound progresses. In addition, a superfluous component may also be formed simultaneously depending on the compositions or the first anisotropic shaped powder and/or reaction raw material.

The heating temperature should be selected to be the optimum temperature according to the composition and so forth of the first anisotropic shaped powder used, the first reaction raw material, and the crystal oriented ceramics to be produced so that the reaction and/or sintering proceed efficiently and a reaction product having the target composition is formed.

For example, in the case of producing crystal oriented ceramics composed of the first KNN compound using an anisotropic shaped powder A having a KNN composition, heating is typically carried out at 900-1300°C. The optimum heating temperature varies according to the composition of the first KNN compound. In addition, heating may be carried out in an atmosphere of air or oxygen or under reduced pressure or in a vacuum. Moreover, the optimum time should be selected for the heating time corresponding to the heating temperature so that the predetermined sintered compact density is obtained.

In addition, in the case a superfluous component is formed due to reaction between the first anisotropic shaped powder and first reaction raw material, the superfluous component may be allowed to remain in the sintered compact as a secondary phase, or the superfluous component may be removed from the sintered compact. In the case of removing the superfluous component, a method by which the superfluous component is removed thermally or a method in which it is removed chemically may be used.

A method for removing a superfluous component thermally consists of heating the sintered compact in which the first KNN compound and a superfluous component have formed (to be referred to as an "intermediate sintered compact") to a predetermined temperature to volatilize the superfluous component. More specifically, preferable examples of this method include a method in which the intermediate sintered compact is heated at a temperature at which volatilization of the superfluous component occurs either under reduced pressure or in a vacuum, and a method in which the intermediate sintered compact is heated for an extended period of time at a temperature at which volatilization of the superfluous component occurs either in air or in oxygen.

The optimum temperature should be selected for the heating temperature during thermal removal of a superfluous component according to the composition of the first KNN compound and/or the superfluous component so that volatilization of the superfluous component proceed efficiently and the formation of byproducts is inhibited. For example, in the case in which the superfluous component is single phase bismuth oxide, the heating temperature is preferably 800-1300°C, and more preferably 1000-1200°C.

A method for chemically removing a superfluous component consists of immersing the intermediate sintered compact in a treatment liquid having the property of eroding only the superfluous component followed by extraction of the superfluous component. The optimum treatment liquid used should be selected according to the composition of the first KNN compound and/or the superfluous component. For example, in the case in which the superfluous component is single phase bismuth oxide, an acid such as nitric acid or hydrochloric acid is preferably used for the treatment liquid. Nitric acid is particularly preferable as a treatment liquid for chemically extracting a superfluous component having bismuth oxide for its main component.

The reaction between the first anisotropic shaped powder and first reaction raw material and the removal of superfluous component may be carried out simultaneously, successively or independently. For example, the sintered compact may be heated directly under reduced pressure or in a vacuum to a temperature at which both reaction between the first anisotropic shaped powder and first reaction raw material and volatilization of superfluous components proceed efficiently, after which a superfluous component may be removed simultaneous to the reaction.

In addition, the sintered compact may be heated, for example, in air or in oxygen to a temperature at which reaction between the first anisotropic shaped powder and first reaction raw material proceeds efficiently, and after an intermediate sintered compact has been formed, the sintered comtact is subsequently heated under reduced pressure or in a vacuum to a temperature at which volatilization of a superfluous component proceeds smoothly, followed by removal of the superfluous component. Alternatively, after having formed an intermediate sintered compact, the intermediate sintered compact may subsequently be heated in air or oxygen for an extended period of time at a temperature at which volatilization of a superfluous component proceeds efficiently to remove the superfluous component. In addition, after having formed an intermediate sintered compact and then cooling the intermediate sintered compact to room temperature, for example, the intermediate sintered compact may be immersed in a treatment liquid to chemically remove a superfluous component. Alternatively, after having formed an intermediate sintered compact and cooling to room temperature, the intermediate sintered compact may be heated again to a predetermined temperature in a predetermined atmosphere to thermally remove a superfluous component.

Furthermore, in the case the molded product contains a binder, heat treatment may be carried out for the purpose of debinding prior to the heat treatment step. In this case, the temperature of debinding should be a temperature that is at least adequate for thermally debinding the binder. However, in the case easily volatilized substances (such as Na compounds) are contained in the raw material, debinding is preferably carried out at 500°C or lower.

In addition, when an oriented molded product is defound, there are cases in which the degree of orientation of the first anisotropic shaped powder in the oriented molded product may decrease, or volumetric expansion may occur in the oriented molded product. In such cases, cold isotatic pressure (CIP) treatment is preferably additionally carried out on the oriented molded product after debinding but before heat treatment. If hydrostatic pressure treatment is additionally carried out on an oriented molded product after debinding, there is the advantage of being able suppress decreases in the degree of orientation or decreases in sintered compact density caused by volumetric expansion of the oriented molded product.

In addition, in the case of formation of a superfluous component due to reaction between the first anisotropic shaped powder and first reaction raw material, during removal of a superfluous component, hydrostatic pressure treatment may be additionally carried out on the intermediate sintered compact from which a superfluous component has been removed followed by re-sintering. In addition, a method in which hot pressing is additionally carried out on the sintered compact following heat treatment is also effective for further enhancing the sintered compact density and degree of orientation. Moreover, the addition of a compound fine powder, hydrostatic pressure treatment and a hot press method may also be combined.

Next, an explanation is provided of the action of the crystal oriented ceramics production method as claimed in the present invention. when the first anisotropic shaped powder and the first reaction raw material are mixed, and this mixture is molded using a molding method such that force acts on the first anisotropic shaped powder from a single direction, the first anisotropic shaped powder is oriented in the molded product due to shear stress that acts on the first anisotropic shaped powder. When such a molded product is heated at a predetermined temperature, the first anisotropic shaped powder and first reaction raw material react resulting in the formation of a first KNN compound.

At this time, since there is lattice coherency between the growth plane of the first anisotropic shaped powder and a specific crystal plane of the first KNN compound, the growth plane of the first anisotropic shaped powder is inherited as a specific crystal plane of the first KNN compound formed. Consequently, anisotropic shaped crystals of the first KNN compound are formed in a sintered compact in which a specific crystal plane is oriented in a single direction.

Conventional methods of forming only an isotropic perovskite compound by using an anisotropic shaped powder composed of a layered perovskite composite for the reactive template were only capable of producing crystal oriented ceramics or anisotropic shaped powder composed of an isotropic perovskite compound containing all of the A site elements and B site elements contained in the anisotropic shaped powder and other raw materials.

on the other hand, although it was required that the material of the anisotropic shaped powder used for the reactive template have large anisotropy of the crystal lattice and lattice coherency with the isotropic perovskite compound, depending on the composition of the isotropic perovskite compound to be produced, there were either no such materials that satisfied these conditions or it was extremely difficult to find such a material. Thus, in the case of such conventional methods, there were limitations on controlling the composition of the resulting crystal oriented ceramics or anisotropic shaped powder, and more particularly, on controlling the composition of the A site elements.

In contrast, according to a first method, in which an anisotropic shaped powder A composed of a second KNN compound is synthesized by using a second anisotropic shaped powder composed of a layered perovskite composite that facilitates synthesis of an anisotropic shaped powder as a reactive template, followed by producing crystal oriented ceramics by using this anisotropic shaped powder A as a reactive template, crystal oriented ceramics in which an arbitrary crystal plane is oriented can be produced both easily and inexpensively even in the case of a first KNN compound having low crystal lattice anisotropy.

Moreover, if the compositions of the second anisotropic shaped powder and the second reaction raw material are optimized, an anisotropic shaped powder can even be synthesized that does not contain a superfluous A site element. Consequently, crystal oriented ceramics can be produced that facilitates easier control of the composition of A site elements as compared with conventional methods, and which has for its primary phase a first KNN compound having a composition that cannot be obtained with conventional methods.

In addition, according to a second method that uses a second anisotropic shaped powder composed of a layered perovskite composite, a first KNN compound can be synthesized simultaneous to sintering. In addition, if the compositions of the second anisotropic shaped powder oriented in the molded product and the first raw reaction material that reacts with it are optimized, superfluous A site elements can be expelled as superfluous components from the second anisotropic shaped powder simultaneous to synthesis of the first KNN compound.

In addition, in the case of having used a second anisotropic shaped powder that forms a superfluous component that is easily removed either thermally or chemically for the first anisotropic shaped powder, crystal oriented ceramics are obtained that are composed of the first KNN compound but substantially free of superfluous A site elements, and in which a specific crystal plane is oriented.

Moreover, since crystal oriented ceramics obtained according to the method as claimed in the present invention are composed of a first KNN compound containing a predetermined amount of Li, Ta and/or Sb, they exhibit a higher piezoelectric $d_{31}$ constant and electromechanical coupling coefficient $k_p$ as compared with sintered compacts composed of isotropic perovskite in which they are not contained. In addition, since crystal oriented ceramics obtained in this manner have a specific crystal plane oriented at a high degree of orientation, they exhibit a higher piezoelectric $d_{31}$ constant, electromechanical coupling coefficient $k_p$ and piezoelectric $g_{31}$ constant than non-oriented sintered compacts having the same composition.

Example 1

(1) Composition of NN Plate-Like Powder

$Bi_2O_3$ powder, $Na_2CO_3$ powder and $Nb_2O_5$ powder were weighed out to have a composition of $Bi_{2.5}Na_{3.5}Nb_5O_{18}$ in terms of their stoichiometric ratio (to be referred to as "BINN5") followed by their wet mixing. Next, 50 wt% of flux in the form of NaCl was added to this raw material followed by dry mixing for 1 hour.

Next, after placing the resulting mixture in a platinum crucible and heating under conditions of 850°C for 1 hour to completely melt the flux, the mixture was additionally heated under conditions of 1100°C for 2 hours to synthesize BINN5. Furthermore, the rate of the temperature increase was set to 200°C/hour and the temperature was lowered by cooling the oven. Following cooling, the flux was removed by washing the reaction product with hot water to obtain BINN5 powder. The resulting BINN5 powder was a plate-like powder having the {001} plane for its growth plane.

Next, an amount of $Na_2CO_3$ powder required for NN synthesis was added to this BINN5 plate-like powder followed by mixing and then heat treatment at 950°C for 8 hours in a platinum crucible using NaCl as flux.

Since the resulting reaction product contained $Bi_2O_3$ in addition to NN powder, after removing the flux from the reaction product, it was placed in HNO3 (1 N) to dissolve the $Bi_2O_3$ formed as a superfluous component. Moreover, the NN powder was separated by filtering this solution and then washed with ion exchange water at 80°C. The resulting NN powder was a plate-like powder having the pseudo-cubic {100} plane for the growth plane, a particle diameter of 10-20 $\mu$m, and an aspect ratio of about 10-20.

(2) Production of Crystal Oriented Ceramics Having the Composition of ${Li_{0.02}(K_{0.5}Na_{0.5})_{0.98}}{Nb_{0.94}Sb_{0.06}}O_3$

The NN plate-like powder produced in (1) above, non-plate-like NN powder, KN powder, KT ($KTaO_3$) powder, LS ($LiSbO_3$) powder and NS ($NaSbO_3$) powder were weighed out to have the desired composition followed by wet mixing for 20 hours.

After adding 10.35 g each of binder (Sekisui Chemical, S-LEK (registered trademark) BH-3) and plasticizer (butylphthalic acid) to the slurry with respect to 1 mol of $\{Li_{0.02}(K_{0.5}Na_{0.5})_{0.98}\}$ $\{Nb_{0.94}Sb_{0.06}\}O_3$ synthesized from the starting raw material, the mixture was additionally mixed for 2 hours.

Furthermore, the blended amount of NN plate-like powder was taken to be the amount for which 5 at% of the A site elements of a first KNN solid solution ($ABO_3$) synthesized from the starting raw material are supplied from the NN plate-like powder. In addition, the non-plate-like NN powder, KN powder, KT powder, LS powder and NS powder were produced according to the solid phase method in which mixtures containing predetermined amounts of $K_2CO_3$ powder, $Na_2CO_3$ powder, $Nb_2O_5$ powder, $Ta_2O_5$ powder and/or $Sb_2O_5$ powder were heated for 5 hours at 750°C followed by crushing the reaction products with a ball mill.

Next, the mixed slurry was formed into the shape of a tape having a thickness of 100 $\mu$m using a doctor blade device. Moreover, a plate-like molded product having a thickness of 1.5 mm was obtained by laminating, pressing and rolling this tape. Next, the resulting plate-like molded product was defound in air under the conditions of a heating temperature of 600°C, heating time of 2 hours, rate of temperature increase of 50°C/hour and cooling rate equal to the rate of oven cooling. Moreover, after subjecting the defound plate-like molded product to CIP treatment at a pressure of 300 MPa, it was sintered under normal pressure in oxygen under conditions of a sintering temperature of 1100°C, heating time of 1 hour, and rate of temperature increase and decrease of 200°C/hour.

The sintered compact density, the average degree of orientation F(100) according to the Lotgering method of the {100} plane for a plane parallel to the tape surface, along with piezoelectric characteristics consisting of the piezo-electric strain constant ($d_{31}$), electromechanical coupling coefficient ($k_p$) and piezoelectric voltage sensor g coefficient ($g_{31}$) were measured for the resulting sintered compact.

Furthermore, the average degree of orientation F(100) was calculated using Equation 1. In addition, the piezoelectric characteristics were measured under conditions of an electric field strength of 1 V/mm according to the resonance- anti-resonance method at room temperature under the condition of the electric field 1 V/mm by fabricating a disc-shaped sample having a thickness of 0.7 mm and diameter of 11 mm, and in which its upper and lower surfaces are parallel to the tape surface, from the resulting sintered compact by grinding, polishing and machining, coating the upper and lower surfaces with Au electrodes by sputtering, and performing polarization treatment in the upward and downward directions of the disc-shaped sample. Temperature dependency of the piezoelectric $d_{31}$ constant over a temperature range of 0-200°C and Curie temperature were evaluated as necessary.

The relative density of the crystal oriented ceramics obtained in this example was 95% or more. In addition, the pseudo-cubic {100} plane was oriented parallel to the tape surface, and the average degree of orientation of the pseudo-cubic {100} plane as determined by the Lotgering method reached 82%. Moreover, as a result of evaluating the piezoelectric characteristics at room temperature, $d_{31}$ was 85.9 pm/V, $k_p$ was 0.532 and $g_{31}$ was 15.6 x $10^{-3}$ Vm/N. These values represented an improvement of 1.29 times, 1.22 times and 1.69 times, respectively, as compared with a non-oriented sintered compact of the same composition (Comparative Example 1) to be described later. In addition, this crystal oriented ceramics had a value of $d_{31}$ that was roughly twice that of KNN crystal oriented ceramics (Comparative Example 5) to which Li, Ta and Sb were not added to be described later.

Example 2

Crystal oriented ceramics having the composition of $\{Li_{0.02}(K_{0.5}Na_{0.5})_{0.98}\}\{Nb_{0.94}Sb_{0.06}\}O_3$ was produced according to the same procedure as Example 1 with the exception of making the sintering temperature of the plate-like molded product after debinding 1125°C. Sintered compact density, average degree of orientation and piezoelectric characteristics were measured for the resulting crystal oriented ceramics under the same conditions as Example 1.

The relative density of the crystal oriented ceramics obtained in this example was 95% or more. In addition, the pseudo-cubic {100} plane was oriented parallel to the tape surface, and the average degree of orientation of the pseudo-cubic {100} plane as determined by the Lotgering method reached 82%. Moreover, as a result of evaluating the piezoelectric characteristics at room temperature, $d_{31}$ was 93.2 pm/V, $k_p$ was 0.588 and $g_{31}$ was 16.5 x $10^{-3}$ Vm/N. These values represented an improvement of 1.40 times, 1.35 times and 1.79 times, respectively, as compared with a non-oriented sintered compact of the same composition (Comparative Example 1) to be described later. Moreover, as a result of evaluating the temperature dependency of $d_{31}$, the maximum value of $d_{31}$ over a range of 0-200°C reached 146.7 pm/V, which represented an improvement of 1.17 times as compared with Comparative Example 1. In addition, the Curie temperature was 311°C.

Example 3

Crystal oriented ceramics having the composition of $\{Li_{0.02}(K_{0.5}Na_{0.5})_{0.98}\}\{Nb_{0.88}Ta_{0.10}Sb_{0.02}\}O_3$ was produced according to the same procedure as Example 1 with the exception of blending the starting raw materials so that the composition was $\{Li_{0.02}(K_{0.5}Na_{0.5})_{0.98}\}\{Nb_{0.88}Ta_{0.10}Sb_{0.02}\}O_3$ and making the sintering temperature of the plate-like molded product after debinding 1125°C. Sintered compact density, average degree of orientation and piezoelectric characteristics were measured for the resulting crystal oriented ceramics under the same conditions as Example 1.

The relative density of the crystal oriented ceramics obtained in this example was 95% or more. In addition, the pseudo-cubic {100} plane was oriented parallel to the tape surface, and the average degree of orientation of the pseudo-cubic {100} plane as determined by the Lotgering method reached 81%. Moreover, as a result of evaluating the piezoelectric characteristics at room temperature, $d_{31}$ was 79.9 pm/V, $k_p$ was 0.537 and $g_{31}$ was 16.0 x $10^{-3}$ Vm/N. These values represented an improvement of 1.20 times, 1.20 times and 1.67 times, respectively, as compared with a non-oriented sintered compact of the same composition (Comparative Example 2) to be described later.

## Example 4

Crystal oriented ceramics having the composition of $\{Li_{0.02}(K_{0.5}Na_{0.5})_{0.98}\}\{Nb_{0.81}Ta_{0.14}Sb_{0.05}\}O_3$ was produced according to the same procedure as Example 1 with the exception of blending the starting raw materials so that 2 at% of the A site elements are supplied from an NN plate-like powder, that the composition was $\{Li_{0.02}(K_{0.5}Na_{0.5})_{0.98}\}\{Nb_{0.81}Ta_{0.14}Sb_{0.05}\}O_3$, and making the sintering temperature of the plate-like molded product after degreasing 1150°C. Sintered compact density, average degree of orientation and piezoelectric characteristics were measured for the resulting crystal oriented ceramics under the same conditions as Example 1.

The relative density of the crystal oriented ceramics obtained in this example was 95% or more. In addition, the pseudo-cubic {100} plane was oriented parallel to the tape surface, and the average degree of orientation of the pseudo-cubic {100} plane as determined by the Lotgering method reached 75%. Moreover, as a result of evaluating the piezoelectric characteristics at room temperature, $d_{31}$ was 123.0 pm/V, $k_p$ was 0.588 and $g_{31}$ was 11.8 x $10^{-3}$ Vm/N. These values represented an improvement of 1.54 times, 1.45 times and 1.63 times, respectively, as compared with a non-oriented sintered compact of the same composition (Comparative Example 3) to be described later.

## Example 5

Crystal oriented ceramics having the composition of $\{Li_{0.02}(K_{0.5}Na_{0.5})_{0.98}\}\{Nb_{0.81}Ta_{0.14}Sb_{0.05}\}O_3$ was produced according to the same procedure as Example 1 with the exception of blending the starting raw materials so that the composition was $\{Li_{0.02}(K_{0.5}Na_{0.5})_{0.98}\}\{Nb_{0.81}Ta_{0.14}Sb_{0.05}\}O_3$ and making the sintering temperature of the plate-like molded product after debinding 1150°C. Sintered compact density, average degree of orientation and piezoelectric characteristics were measured for the resulting crystal oriented ceramics under the same conditions as Example 1.

The relative density of the crystal oriented ceramics obtained in this example was 95% or more. In addition, the pseudo-cubic {100} plane was oriented parallel to the tape surface, and the average degree of orientation of the pseudo-cubic {100} plane as determined by the Lotgering method reached 72%. Moreover, as a result of evaluating the piezoelectric characteristics at room temperature, $d_{31}$ was 116.6 pm/V, $k_p$ was 0.540 and $g_{31}$ was 10.3 x $10^{-3}$ Vm/N. These values represented an improvement of 1.46 times, 1.33 times and 1.43 times, respectively, as compared with a non-oriented sintered compact of the same composition (Comparative Example 3) to be described later. Moreover, as a result of evaluating the temperature dependency of $d_{31}$, the maximum value of $d_{31}$ over a range of 0-200°C reached 123.2 pm/V, which represented an improvement of 1.18 times as compared with Comparative Example 3. In addition, the Curie temperature was 248°C.

## Example 6

Crystal oriented ceramics having the composition of $\{Li_{0.02}K_{0.5}Na_{0.5})_{0.98}\}\{Nb_{0.81}Ta_{0.14}Sb_{0.05}\}O_3$ was produced according to the same procedure as Example 1 with the exception of blending the starting raw materials so that the composition was $\{Li_{0.02}(K_{0.5}Na_{0.5})_{0.98}\}\{Nb_{0.81}Ta_{0.14}Sb_{0.05}\}O_3$, making the sintering temperature of the plate-like molded product after debinding 1150°C and making the heating time 5 hours. Sintered compact density, average degree of orientation and piezoelectric characteristics were measured for the resulting crystal oriented ceramics under the same conditions as Example 1.

The relative density of the crystal oriented ceramics obtained in this example was 95% or more. In addition, the pseudo-cubic {100} plane was oriented parallel to the tape surface, and the average degree of orientation of the pseudo-cubic {100} plane as determined by the Lotgering method reached 85%. Moreover, as a result of evaluating the piezoelectric characteristics at room temperature, $d_{31}$ was 135.3 pm/V, $k_p$ was 0.606 and $g_{31}$ was 14.8 x $10^{-3}$ Vm/N. These values represented an improvement of 1.70 times, 1.49 times and 2.06 times, respectively, as compared with a non-oriented sintered compact of the same composition (Comparative Example 3) to be described later. Moreover, as a result of evaluating the temperature dependency of $d_{31}$, the maximum value of $d_{31}$ over a range of 0-200°C reached 146.4 pm/V, which represented an improvement of 1.40 times as compared with Comparative Example 3. In addition, the Curie temperature was 248°C.

Example 7

Crystal oriented ceramics having the composition of $\{Li_{0.02}(K_{0.5}Na_{0.5})_{0.98}\}\{Nb_{0.81}Ta_{0.14}Sb_{0.05}\}O_3$ was produced according to the same procedure as Example 1 with the exception of blending the starting raw materials so that the composition was $\{Li_{0.02}(K_{0.5}Na_{0.5})_{0.98}\}\{Nb_{0.81}Ta_{0.14}Sb_{0.05}\}O_3$ and hot pressing the defound plate-like molded product in oxygen under the conditions of a sintering temperature of 1150°C, heating time of 1 hour, pressurization pressure of 35 kg/cm$^2$ (3.43 MPa) and rate of temperature increase and decrease of 200°C/hour. Sintered compact density, average degree of orientation and piezoelectric characteristics were measured for the resulting crystal oriented ceramics under the same conditions as Example 1.

The relative density of the crystal oriented ceramics obtained in this example was 95% or more. In addition, the pseudo-cubic {100} plane was oriented parallel to the tape surface, and the average degree of orientation of the pseudo-cubic {100} plane as determined by the Lotgering method reached 85%. Moreover, as a result of evaluating the piezoelectric characteristics at room temperature, $d_{31}$ was 131.8 pm/V, $k_p$ was 0.663 and $g_{31}$ was 15.5 x 10$^{-3}$ Vm/N. These values represented an improvement of 1.65 times, 1.63 times and 2.15 times, respectively, as compared with a non-oriented sintered compact of the same composition (Comparative Example 3) to be described later. Moreover, as a result of evaluating the temperature dependency of $d_{31}$, the maximum value of $d_{31}$ over a range of 0-200°C reached 204.8 pm/V, which represented an improvement of 1.96 times as compared with Comparative Example 3. In addition, the Curie temperature was 248°C.

Example 8

Crystal oriented ceramics having the composition of $\{Li_{0.02}(K_{0.5}Na_{0.5})_{0.98}\}\{Nb_{0.81}Ta_{0.14}Sb_{0.05}\}O_3$ was produced according to the same procedure as Example 1 with the exception of blending the starting raw materials so that the composition was $\{Li_{0.02}(K_{0.5}Na_{0.5})_{0.98}\}\{Nb_{0.81}Ta_{0.14}Sb_{0.05}\}O_3$ and hot pressing the defound plate-like molded product in oxygen under the conditions of a sintering temperature of 1150°C, heating time of 5 hours, pressurization pressure of 50 kg/cm$^2$ (4.90 MPa) and rate of temperature increase and decrease of 200°C/hour. Sintered compact density, average degree of orientation and piezoelectric characteristics were measured for the resulting crystal oriented ceramics under the same conditions as Example 1.

The relative density of the crystal oriented ceramics obtained in this example was 95% or more. In addition, the pseudo-cubic {100} plane was oriented parallel to the tape surface, and the average degree of orientation of the pseudo-cubic {100} plane as determined by the Lotgering method reached 96%. Moreover, as a result of evaluating the piezoelectric characteristics at room temperature, $d_{31}$ was 126.8 pm/V, $k_p$, was 0.655 and $g_{31}$ was 17.2 x 10$^{-3}$ Vm/N. These values represented an improvement of 1.59 times, 1.61 times and 2.39 times, respectively, as compared with a non-oriented sintered compact of the same composition (Comparative Example 3) to be described later. Moreover, as a result of evaluating the temperature dependency of $d_{31}$, the maximum value of $d_{31}$ over a range of 0-200°C reached 177.1 pm/V, which represented an improvement of 1.70 times as compared with Comparative Example 3. In addition, the Curie temperature was 248°C.

Example 9

Crystal oriented ceramics having the composition of $\{Li_{0.04}(K_{0.46}Na_{0.54})_{0.96}\}\{Nb_{0.84}Ta_{0.10}Sb_{0.06}\}O_3$ was produced according to the same procedure as Example 1 with the exception of blending the starting raw materials so that the composition was $\{Li_{0.04}(K_{0.46}Na_{0.54})_{0.96}\}\{Nb_{0.84}Ta_{0.10}Sb_{0.06}\}O_3$ and hot pressing the defound plate-like molded product in oxygen under the conditions of a sintering temperature of 1150°C, heating time of 1 hour, pressurization pressure of 35 kg/cm$^2$ (3.43 MPa) and rate of temperature increase and decrease of 200°C/hour. Sintered compact density, average degree of orientation and piezoelectric characteristics were measured for the resulting crystal oriented ceramics under the same conditions as Example 1.

Moreover, the displacement generated in a direction parallel to the direction in which voltage was applied in the case of driving by applying a high voltage having an electric field strength of 0-2000 V/mm at a frequency of 1 Hz in the form of a chopping wave having a frequency of 1 Hz over a temperature range of -42 to 162°C was evaluated by determining as the amount of dynamic strain ($D_{33large}$) according to equation A6. In addition, the amount of injection charge during driving in a high electric field was calculated as the dielectric constant (dynamic dielectric constant: $E_{33large}$) according to equation A9.

The relative density of the crystal oriented ceramics obtained in this example was 95% or more. In addition, the pseudo-cubic {100} plane was oriented parallel to the tape surface, and the average degree of orientation of the pseudo-cubic {100} plane as determined by the Lotgering method reached 92%. Moreover, as a result of evaluating the piezoelectric characteristics at room temperature, $d_{31}$ was 166.1 pm/V, $k_p$ was 0.664 and $g_{31}$ was 14.3 x $10^{-3}$ Vm/N. These values represented an improvement of 1.25 times, 1.30 times and 2.04 times, respectively, as compared with a non-oriented sintered compact of the same composition (Comparative Example 6) to be described later. Moreover, as a result of evaluating the temperature dependency of $d_{31}$, the maximum value of $d_{31}$ over a range of 0-200°C reached 180.1 pm/V, which represented an improvement of 1.30 times as compared with Comparative Example 6. In addition, the Curie temperature was 260°C.

Moreover, as a result of evaluating the displacement generated in the case of driving by applying a high voltage (electric field strength: 0-2000 V/mm) in the form of a chopping wave having a frequency of 1 Hz, the maximum value of $D_{33large}$ at a temperature of 24-162 °C (temperature range: 138°C) was 800 pm/V, the minimum value was 750, and the amount of fluctuation with respect to their average value (775 pm/V) was ±3%. In addition, as a result of evaluating $E_{33large}$ during driving at this time, the maximum value of $E_{33large}$ at a temperature of 24-162°C (temperature range: 138°C) was 3219, the minimum value of $E_{33large}$ was 2824, and the amount of fluctuation with respect to their average value (3021 pm/V) was ±6.5%.

On the basis of the aforementioned measurement results, the temperature characteristics of an actuator using the material of the present example in a driving method other than constant voltage driving were determined by calculation. According to equations A5, A7, A8 and A10, the displacement in the case of driving an actuator in a constant electric field is proportional to $D_{33large}$, the displacement in the case of driving an actuator at a constant energy is proportional to $D_{33large}/ (E_{33large})^{1/2}$ of the actuator, and the displacement in the case of driving an actuator at constant injection charge is proportional to $D_{33large}/E_{33large}$ of the actuator. Calculations were made in the cases of the aforementioned constant voltage driving (characteristic index: $D_{33large}$), constant energy driving (characteristic index: $D_{33large}/ (E_{33large})^{1/2}$ and constant charge driving (characteristic index: $D_{33large}/E_{33large}$) for the material obtained in the present example. As a result, the maximum value of $D_{33large}$ at a temperature of 24-162°C (temperature range: 138°C) was 800 pm/V, the minimum value of $D_{33large}$ was 750 pm/V, and the amount of fluctuation with respect to their average value (775 pm/V) was ±3%. In addition, the maximum value of $D_{33large}/ (E_{33large})^{1/2}$ was 15.06 pm/V, the minimum value was 14.10 pm/V, and the amount of fluctuation with respect to their average value (14.58 pm/V) was ±3%. Moreover, the maximum value of $D_{33large}/E_{33large}$ was 0.2833 pm/V, the minimum value was 0.2485 pm/V, and the amount of fluctuation with respect to their average value (0.2659 pm/V) was ±6.5%.

Comparative Example 1

A non-oriented sintered compact having the composition of $\{Li_{0.02}(K_{0.5}Na_{0.5})_{0.98}\}\{Nb_{0.94}Sb_{0.06}\}O_3$ was produced according to the same procedure as Example 1 with the exception of not using NN plate-like powder as a starting raw material. Sintered compact density, average degree of orientation and piezoelectric characteristics were measured for the resulting non-oriented sintered compact under the same conditions as Example 1.

The relative density of the non-oriented sintered compact obtained in this comparative example was 95% or more. In addition, average degree of orientation of the pseudo-cubic {100} plane as determined by the Lotgering method for a plane parallel to the tape surface was 0%. In addition, as a result of evaluating the piezoelectric characteristics at room temperature, $d_{31}$ was 66.8 pm/V, $k_p$ was 0.435 and $g_{31}$ was 9.2 x $10^{-3}$ Vm/N. Moreover, the maximum value of $d_{31}$ over a range of 0-200°C was 125.4 pm/V. In addition, the Curie temperature was 311°C.

Comparative Example 2

A non-oriented sintered compact having the composition of $\{Li_{0.02}(K_{0.5}Na_{0.5})_{0.98}\}\{Nb_{0.88}Ta_{0.10}Sb_{0.02}\}O_3$ was produced according to the same procedure as Example 1 with the exception of not using NN plate-like powder as a starting raw material. Sintered compact density, average degree of orientation and piezoelectric characteristics were measured for the resulting non-oriented sintered compact under the same conditions as Example 1.

The relative density of the non-oriented sintered compact obtained in this comparative example was 95% or more. In addition, average degree of orientation of the pseudo-cubic {100} plane as determined by the Lotgering method for a plane parallel to the tape surface was 0%. Moreover, as a result of evaluating the piezoelectric characteristics at room temperature, $d_{31}$ was 66.4 pm/V, $k_p$ was 0.446 and $g_{31}$ was 9.5 x $10^{-3}$ Vm/N.

Comparative Example 3

A non-oriented sintered compact having the composition of $\{Li_{0.02}(K_{0.5}Na_{0.5})_{0.98}\}\{Nb_{0.81}Ta_{0.14}Sb_{0.05}\}O_3$ was produced according to the same procedure as Example 5 with the exception of not using NN plate-like powder as a starting raw material. Sintered compact density, average degree of orientation and piezoelectric characteristics were measured for the resulting non-oriented sintered compact under the same conditions as Example 1.

The relative density of the non-oriented sintered compact obtained in this comparative example was 95% or more. In addition, average degree of orientation of the pseudo-cubic {100} plane as determined by the Lotgering method for a plane parallel to the tape surface was 0%. Moreover, as a result of evaluating the piezoelectric characteristics at room temperature, $d_{31}$ was 79.7 pm/V, $k_p$ was 0.406 and $g_{31}$ was 7.2 x $10^{-3}$ Vm/N. Moreover, the maximum value of $d_{31}$ over a range of 0-200°C was 104.3 pm/V. In addition, the Curie temperature was 248°C.

Comparative Example 4

A non-oriented sintered compact having the composition of $\{Li_{0.02}(K_{0.5}Na_{0.5})_{0.98}\}\{Nb_{0.81}Ta_{0.14}Sb_{0.05}\}O_3$ was produced according to the same procedure as Example 7 with the exception of not using NN plate-like powder as a starting raw material. Sintered compact density, average degree of orientation and piezoelectric characteristics were measured for the resulting non-oriented sintered compact under the same conditions as Example 1.

The relative density of the non-oriented sintered compact obtained in this comparative example was 95% or more. In addition, average degree of orientation of the pseudo-cubic {100} plane as determined by the Lotgering method for a plane parallel to the tape surface was 0%. Moreover, as a result of evaluating the piezoelectric characteristics at room temperature, $d_{31}$ was 77.0 pm/V, $k_p$ was 0.434 and $g_{31}$ was 7.6 x $10^{-3}$ Vm/N. Each of these characteristics exhibited a lower value than those of Example 7 which used NN plate-powder for the template.

Comparative Example 5

The NN plate-like powder produced in part (1) of Example 1, a non-plate-like NN powder and KN powder were weighed out to a composition of $(K_{0.5}Na_{0.5})NbO_3$ and wet mixed for 20 hours. Furthermore, the blended amount of NN plate-like powder was the amount for which 5 at% of the A site elements are supplied from the NN plate-like powder.

Next, 10.35 g of binder (Sekisui Chemical, S-LEK (registered trademark) BH-3), 10.35 g of plasticizer (butylphthalic acid) and 0.795 g of sintering aid (CuO) were added to the slurry with respect to 1 mol of $(K_{0.5}Na_{0.5})NbO_3$ synthesized from the starting raw materials, followed by mixing for 2 hours. A plate-like molded product was then produced, defound and subjected to CIP treatment in accordance with the same procedure as Example 1.

Moreover, the defound plate-like molded product was sintered at normal pressure under conditions of a heating temperature of 1075°C, heating time of 5 hours and rate of temperature increase and decrease of 200°C/hour. Sintered compact density, average degree of orientation and piezoelectric characteristics were measured for the resulting crystal oriented ceramics under the same conditions as Example 1.

The relative density of the KNN crystal oriented ceramics obtained in this comparative example was 95% or more. In addition, average degree of orientation of the pseudo-cubic {100} plane as determined by the Lotgering method for a plane parallel to the tape surface was 96%. Moreover, as a result of evaluating the piezoelectric characteristics at room temperature, $d_{31}$ was 42.4 pm/V, $k_p$ was 0.490 and $g_{31}$ was 22.0 x $10^{-3}$ Vm/N.

Comparative Example 6

A non-oriented sintered compact having the composition of $\{Li_{0.04}\{K_{0.46}Na_{0.54}\}_{0.96}\}\{Nb_{0.84}Ta_{0.10}Sb_{0.06}\}O_3$ was produced according to the same procedure as Example 9 with the exception of not using NN plate-like powder and carrying out sintering at normal pressure under conditions of a heating temperature of 1125°C, heating time of 1 hour and rate of temperature increase and decrease of 200°C/hour, instead of hot pressing. Sintered compact density, average degree of orientation and piezoelectric characteristics were measured for the resulting non-oriented sintered compact under the same conditions as Example 1.

Moreover, $D_{33large}$ and $E_{33large}$ were evaluated in the case of driving by applying a high voltage (electric field strength: 0-2000 V/mm) in the form of a chopping wave having a frequency of 1 Hz under the same conditions as Example 9.

The relative density of the non-oriented sintered compact obtained in this comparative example was 95% or more. In addition, average degree of orientation of the pseudo-cubic {100} plane as determined by the Lotgering method for a plane parallel to the tape surface was 0%. In addition, as a result of evaluating the piezoelectric characteristics at room temperature, $d_{31}$ was 132.4 pm/V, $k_p$ was 0.511 and $g_{31}$ was 7.0 x $10^{-3}$ Vm/N. Moreover, the maximum value of $d_{31}$ over a range of 0-200°C was 138.7 pm/V. In addition, the Curie temperature was 260°C.

In addition, as a result of evaluating displacement generated in the case of driving by applying a high voltage (electric field strength: 0-2000 V/mm) in the form of a chopping wave having a frequency of 1 Hz, the maximum value of $D_{33large}$ at a temperature of 52-165°C (temperature range: 113°C) was 450 pm/V, the minimum value of $D_{33large}$ was 275 pm/V, and the amount of fluctuation with respect to their average value (363 pm/V) was ±24%. In addition, as a result of evaluating $E_{33large}$ during driving at this time, the maximum value of $E_{33large}$ at a temperature of 52-165°C (temperature range: 113°G) was 2711, the minimum value of $E_{33large}$ was 1995, and the amount of fluctuation with respect to their average value (2344) was ±15.2%.

On the basis of the aforementioned measurement results, calculations were made for the material obtained in Comparative Example 6 using the same method as in the case of Example 9 in the case of constant voltage driving (characteristic index: $D_{33large}$), constant energy driving (characteristic index: $D_{33large}/(E_{33large})^{1/2}$) and constant charge driving (characteristic index: $E_{33large}$). As a result, the maximum value of $D_{33large}$ at a temperature of 52-165°C (temperature range: 113°C) was 450 pm/V, the minimum value was 275 pm/V, and the amount of fluctuation with respect to their average value (363 pm/V) was ±24%. In addition, the maximum value of $D_{33large}/(E_{33large})^{1/2}$ was 8.64 pm/V, the minimum value was 6.16 pm/V, and the amount of fluctuation with respect to their average value (7.40 pm/V) was ±17%. Moreover, the maximum value of $D_{33large}/E_{33large}$ was 0.1660 pm/V, the minimum value was 0.1378 pm/V, and the amount of fluctuation with respect to their average value (0.1519 pm/V) was ±9.3%.

Example 22

Crystal oriented ceramics having the composition of $\{Li_{0.08}(K_{0.5}Na_{0.5})_{0.92}\}\{Nb_{0.84}Ta_{0.10}Sb_{0.06}\}O_3$ was produced according to the same procedure as Example 1 with the exception of blending the starting raw materials so that the composition was $\{Li_{0.08}(K_{0.5}Na_{0.5})_{0.92}\}\{Nb_{0.84}Ta_{0.10}Sb_{0.06}\}O_3$ and making the sintering temperature of the plate-like molded product after degreasing 1105°C. A disc-shaped sample having a thickness of 0.5 mm and diameter of 8.5 mm and in which its upper and lower surfaces were parallel to the tape surface was fabricated from the resulting sintered compact by grinding, polishing and machining, after which Au baked electrodes were baked onto the entire upper and lower surfaces of the disc-shaped sample in air using a mesh belt oven under conditions of a baking temperature of 850° and heating time of 10 minutes. After performing polarization treatment in the vertical direction of this disc-shaped sample, forty sheets of the resulting crystal oriented ceramics were laminated to produce an actuator. Sintered compact density and average degree of orientation were evaluated in accordance with the same procedure as Example 1, and D33large and E33large were evaluated in the case of driving by applying an electric field strength of 0-1500 V/mm in the form of a sine wave having a frequency of 1 Hz under a spring load of 2.9 N/$\mu$m over a temperature range of -40 to 160°C in the state in which a preset load of 16.4 MPa was applied to the resulting actuator.

The relative density of the crystal oriented ceramics obtained in this example was 95% or more. The pseudo-cubic {100} plane was oriented parallel to the tape surface, and the average degree of orientation of the pseudo-cubic {100} plane as determined according to the Lotgering method was 89%.

In addition, as a result of evaluating displacement generated in the case of driving by applying a high voltage (electric field strength: 0-1500 V/mm) in the form of a sine wave having a frequency of 1 Hz, the maximum value of $D_{33large}$ at a temperature of -40 to 70°C (temperature range: 110°C) was 322 pm/V, the minimum value of $D_{33large}$ was 287 pm/V, and the amount of fluctuation with respect to their average value (305 pm/V) was ±6%. In addition, as a result of evaluating $E_{33large}$ during driving at this time, the maximum value of $E_{33large}$ at a temperature of -40 to 70°C (temperature range: 110°C) was 1620, the minimum value of $E_{33large}$ was 1444, and the amount of fluctuation with respect to their average value (1532 pm/V) was ±6%.

On the basis of the aforementioned measurement results, calculations were made for the material obtained in Example 22 using the same method as in the case of Example 9 in the case of constant voltage driving (characteristic index: $D_{33large}$), constant energy driving (characteristic index: : $D_{33large}/(E_{33large})^{1/2}$) and constant charge driving (characteristic index: $E_{33large}$). As a result, the maximum value of $D_{33large}$ at a temperature of - 40 to 70°C (temperature range: 110°C) was 322 pm/V, the minimum value was 287 pm/V, and the amount of fluctuation with respect to their average value (305 pm/V) was ±6%. In addition, the maximum value of $D_{33large}/(E_{33large})^{1/2}$ was 8.28 pm/V, the minimum value was 7.18 pm/V, and the amount of fluctuation with respect to their average value (7.73 pm/V) was ±7.1%. Moreover, the maximum value of $D_{33large}/E_{33large}$ was 0.2130 pm/V, the minimum value was 0.1784 pm/V, and the amount of fluctuation with respect to their average value (0.1957 pm/V) was ±8.8%.

In addition, as a result of evaluating $D_{33large}$ and $E_{33large}$ for a single plate in the case of applying a high voltage in the form of a sine wave and chopping wave having a frequency of 1 Hz using the same method as the case of Example 9, satisfactory temperature characteristics similar to the case of an actuator were obtained in both electric fields (sine wave and chopping wave).

Example 23

Crystal oriented ceramics having the composition of $\{Li_{0.07}(K_{0.43}Na_{0.57})_{0.93}\}\{Nb_{0.84}Ta_{0.09}Sb_{0.07}\}O_3$ was produced according to the same procedure as Example 1 with the exception of blending the starting raw materials so that the composition was $\{Li_{0.07}(K_{0.43}Na_{0.57})_{0.93}\}\{Nb_{0.84}Ta_{0.09}Sb_{0.07}\}O_3$ and hot pressing the degreased plate-like molded product in oxygen under the conditions of a sintering temperature of 1130°C, heating time of 5 hours, pressurization pressure of 35 kg/cm$^2$ (3.43 MPa) and rate of temperature increase and decrease of 200°C/hour. The resulting crystal oriented ceramics was evaluated for sintered compact density and average degree of orientation under the same conditions as Example 1, and $D_{33large}$ and $E_{33large}$ were evaluated under the same conditions as Example 9 in the case of driving by applying a high voltage (electric field strength: 0-2000 V/mm) in the form of a chopping wave having a frequency of 1 Hz. In addition, the generated displacement and generated electric field were evaluated in the case of driving an element by making injection energy (W) constant (constant energy driving) and making injection charge (Q) constant (constant charge driving).

The relative density of the crystal oriented ceramics obtained in this example was 95% or more. In addition, the pseudo-cubic {100} plane was oriented parallel to the tape surface, and the average degree of orientation of the pseudo-cubic {100} plane as determined according to the Lotgering method reached 78%.

As a result of evaluating displacement generated in the case of driving by applying a high voltage (electric field strength: 0-2000 V/mm) in the form of a chopping wave having a frequency of 1 Hz, the maximum value of $D_{33large}$ at a temperature of -30 to 161°C (temperature range: 191°C) was 692 pm/V, the minimum value of $D_{33large}$ was 650, and the amount of fluctuation with respect to their average value (671 pm/V) was ±3.1%, while the maximum value of $E_{33large}$ at a temperature of -30 to 161°C (temperature range: 191°C) was 2429, the minimum value of $E_{33large}$ was 2315, and the amount of fluctuation with respect to their average value (2372 pm/V) was ±2.4%. In addition, as a result of fabricating an actuator and evaluating $D_{33large}$ of the actuator using the same method as Example 22, satisfactory temperature characteristics similar to the case of evaluating with a single plate were demonstrated.

On the basis of the aforementioned measurement results, calculations were made for the material obtained in Example 23 using the same method as in the case of Example 9 in the case of constant voltage driving (characteristic index: $D_{33large}$), constant energy driving (characteristic index: $D_{33large}/(E_{33large})^{1/2}$) and constant charge driving (characteristic index: $E_{33large}$). As a result, the maximum value of $D_{33large}$ at a temperature of - 30 to 161°C (temperature range: 191°C) was 692 pm/V, the minimum value was 650 pm/V, and the amount of fluctuation with respect to their average value (671 pm/V) was ±3.1%. In addition, the maximum value of $D_{33large}/(E_{33large})^{1/2}$ was 14.04 pm/V, the minimum value was 13.27 pm/V, and the amount of fluctuation with respect to their average value (13.65 pm/V) was ±2.8%. Moreover, the maximum value of $D_{33large}/E_{33large}$ was 0.2849 pm/V, the minimum value was 0.2708 pm/V, and the amount of fluctuation with respect to their average value (0.2778 pm/V) was ±2.5%.

In addition, as a result of evaluating under the same conditions as the case of making the electric field strength 0-2000 V/mm but making the electric field strength 0-500 V/mm, the amounts of fluctuation of $D_{33large}$ and $E_{33large}$ over a predetermined temperature range of 100°C or more were within ±20% and within ±15% in the same manner as the case of using an electric field strength of 0-2000 V/mm.

Moreover, as a result of evaluating the generated displacement and generated electric field were evaluated in the case of driving an element by making injection energy (W) constant (30000 J/m$^3$), the maximum value of displacement at a temperature of -30 to 161°C (temperature range: 191°C) was 1250 ppm, the minimum value of displacement was 1160 ppm, and the amount of fluctuation with respect to their average value (1205 ppm) was ±3.7%, while the maximum value of the electric field at a temperature of -30 to 161°C (temperature range: 191°C) was 1750 V/mm, the minimum value of the electric field was 1660 V/mm, and the amount of fluctuation with respect to their average value (1705 V/mm) was ±2.6%.

In addition, as a result of evaluating the generated displacement and generated electric field were evaluated in the case of driving an element by making injection charge (Q) constant (3 $\mu$C/cm$^2$), the maximum value of displacement at a temperature of -30 to 161°C (temperature range: 191°C) was 1020 ppm, the minimum value of displacement was 900 ppm, and the amount of fluctuation with respect to their average value (960 ppm) was ±6.3%, while the maximum value of the electric field at a temperature of -30 to 161°C (temperature range: 191°C) was 1550 V/mm, the minimum value of the electric field was 1450 V/mm, and the amount of fluctuation with respect to their average value (1500 V/mm) was ±3.3%.

Comparative Example 7

Crystal oriented ceramics having the composition of $\{Li_{0.22}(K_{0.50}Na_{0.50})_{0.78}\}\{Nb_{0.88}Ta_{0.10}Sb_{0.02}\}O_3$ was produced according to the same procedure as Example 3 with the exception of making the added amount x of Li 0.22 and the sintering temperature 1050°C. Sintered compact density, average degree of orientation and piezoelectric characteristics were measured for the resulting crystal oriented ceramics under the same conditions as Example 1.

The relative density of the crystal oriented ceramics obtained in this comparative example was 95% or more. In addition, average degree of orientation of the pseudo-cubic {100} plane as determined by the Lotgering method for a plane parallel to the tape surface was 53%. However, as a result of evaluating the piezoelectric characteristics at room temperature, $d_{31}$ was 29.9 pm/V, $k_p$ was 0.171 and $g_{31}$ was 3.2 x 10$^{-3}$ Vm/N, with each of these characteristics exhibiting a lower value than those in Example 3 in which the added amount x of Li was 0.02.

Comparative Example 8

Crystal oriented ceramics having the composition of $\{Li_{0.02}(K_{0.50}Na_{0.50})_{0.98}\}\{Nb_{0.53}Ta_{0.45}Sb_{0.02}\}O_3$ was pro-

duced according to the same procedure as Example 3 with the exception of making the added amount z of Ta 0.45 and carrying out hot pressing under conditions of a heating temperature of 1200°C, heating time of 1 hour, pressurization pressure of 35 kg/cm$^2$ (3.43 MPa) and rate of temperature increase and decrease of 200°C/hour, instead of normal pressure sintering. Sintered compact density, average degree of orientation and piezoelectric characteristics were measured for the resulting crystal oriented ceramics under the same conditions as Example 1.

The relative density of the crystal oriented ceramics obtained in this comparative example was 95% or more. In addition, average degree of orientation of the pseudo-cubic {100} plane as determined by the Lotgering method for a plane parallel to the tape surface was 89%. Moreover, as a result of evaluating the piezoelectric characteristics at room temperature, $d_{31}$ was 107.1 pm/V, $k_p$ was 0.469 and $g_{31}$ was 6.4 x 10$^{-3}$ Vm/N. A higher value was exhibited for the d31 constant as compared with Example 3 in which the added amount z of Ti was 0.10. However, since the Curie temperature of this composition is low at 117°C, it is considered to be difficult to use this crystal oriented ceramics as a piezoelectric material for home appliances and automobiles.

Comparative Example 9

Crystal oriented ceramics having the composition of $\{Li_{0.02}(K_{0.50}Na_{0.50})_{0.98}\}$ $\{Nb_{0.68}Ta_{0.10}Sb_{0.22})O_3$ was produced according to the same procedure as Example 3 with the exception of making the added amount w of Sb 0.22 and making the sintering temperature 1150°C. Sintered compact density, average degree of orientation and piezoelectric characteristics were evaluated for the resulting crystal oriented ceramics under the same conditions as Example 1.

The relative density of the crystal oriented ceramics obtained in this comparative example was 95% or more. In addition, average degree of orientation of the pseudo-cubic {100} plane as determined by the Lotgering method for a plane parallel to the tape surface was 79%. However, as a result of evaluating the piezoelectric characteristics at room temperature, $d_{31}$ was 17.1 pm/V, $k_p$ was 0.074 and $g_{31}$ was 8.7 x 10$^{-3}$ Vm/N, with each of the characteristics exhibiting a lower value than those of Example 3 in which the amount added w of Sb was 0.02.

Comparative Example 10

Crystal oriented ceramics having the composition of $\{Li_{0.22}(K_{0.50}Na_{0.50})_{0.78}\}\{Nb_{0.33}Ta_{0.45}Sb_{0.22}\}O_3$ was produced according to the same procedure as Example 3 with the exception of making the added amount x of Li 0.22, the added amount z of Ta 0.45 and the added amount w of Sb 0.22, and making the sintering temperature 1225°C. Sintered compact density, average degree of orientation and piezoelectric characteristics were evaluated for the resulting crystal oriented ceramics under the same conditions as Example 1.

The relative density of the crystal oriented ceramics obtained in this comparative example was 95% or more. In addition, average degree of orientation of the pseudo-cubic {100} plane as determined by the Lotgering method for a plane parallel to the tape surface was 73%. However, as a result of evaluating the piezoelectric characteristics at room temperature, $d_{31}$ was 4.2 pm/V, $k_p$ was 0.030 and $g_{31}$ was 7.2 x 10$^{-3}$ Vm/N, with each of the characteristics exhibiting a lower value than those of Example 3.

Table 1 shows the production conditions and piezoelectric characteristics of the sintered compacts obtained in Examples 1-9 and Comparative Examples 1-10.

Table 1

| | Composition | | | | NaNbO₃ template (at% A site atomic ratio) | Sint. Temp. (°C) | Hold. Temp. (°C) | Pressure (kg/cm²) | Degree Of orientation {100} plane (%) | Piezoelectric characteristics at room temperature | | | Max. d31 (0-200 °C) | Curie temp. (°C) |
| | $x$ | $y$ | $z$ | $w$ | | | | | | d31 Pm/V | $k_p$ | g31 X10⁻³ (Vm/N) | | |
|---|---|---|---|---|---|---|---|---|---|---|---|---|---|---|
| Ex.1 | 0.02 | 0.50 | 0 | 0.06 | 5 | 1100 | 1 | 0 | 82 | 85.9 | 0.532 | 15.6 | -- | -- |
| Ex.2 | 0.02 | 0.50 | 0 | 0.06 | 5 | 1125 | 1 | 0 | 82 | 93.2 | 0.588 | 16.5 | 146-7 | 311 |
| Ex.3 | 0.02 | 0.50 | 0.10 | 0.02 | 5 | 1125 | 1 | 0 | 81 | 79.9 | 0.537 | 16.0 | - | - |
| Ex.4 | 0.02 | 0.50 | 0.14 | 0.05 | 2 | 1150 | 1 | 0 | 75 | 123.0 | 0.588 | 11.8 | - | - |
| Ex.5 | 0.02 | 0.50 | 0.14 | 0.05 | 5 | 1150 | 1 | 0 | 72 | 116.6 | 0.540 | 10.3 | 123.2 | 248 |
| Ex.6 | 0.02 | 0.50 | 0.14 | 0.05 | 5 | 1150 | 5 | 0 | 85 | 135.3 | 0.606 | 14.8 | 146.4 | 248 |
| Ex.7 | 0.02 | 0.50 | 0.14 | 0.05 | 5 | 1150 | 1 | 35 | 85 | 131.8 | 0.663 | 15.5 | 204.8 | 248 |
| Ex.8 | 0.02 | 0.50 | 0.14 | 0.05 | 5 | 1150 | 5 | 50 | 96 | 126.8 | 0.655 | 17.2 | 177.1 | 248 |
| Ex.9 | 0.04 | 0.54 | 0.10 | 0.06 | 5 | 1150 | 1 | 35 | 92 | 166.1 | 0.664 | 14.3 | 180.1 | 260 |
| Comp. Ex.1 | 0.02 | 0.50 | 0 | 0.06 | 0 | 1100 | 1 | 0 | 0 | 66.8 | 0.435 | 9.2 | 125.4 | 311 |
| Comp. Ex.2 | 0.02 | 0.50 | 0.10 | 0.02 | 0 | 1125 | 1 | 0 | 0 | 66.4 | 0.446 | 9.2 | - | - |
| Comp. Ex.3 | 0.02 | 0.50 | 0.14 | 0.05 | 0 | 1150 | 1 | 0 | 0 | 79.7 | 0.406 | 7.2 | 104.3 | 248 |
| Comp. Ex.4 | 0.02 | 0.50 | 0.14 | 0.05 | 0 | 1150 | 1 | 35 | 0 | 77.0 | 0.434 | 7.6 | - | - |
| Comp. Ex.5 | 0 | 0.50 | 0 | 0 | 5 | 1075 | 5 | 0 | 96 | 42.4 | 0.490 | 22.0 | - | - |
| Comp. Ex.6 | 0.04 | 0.54 | 0.10 | 0.06 | 0 | 1125 | 1 | 0 | 0 | 132.4 | 0.511 | 7.0 | 138.7 | 260 |

(continued)

| | Composition | | | | NaNbO$_3$ template (at%(A site atomic ratio) | Sint. Temp. (°C) | Hold. Temp. (°C) | Pressure (kg/ cm$^2$) | Degree Of orientation {100} plane (%) | Piezoelectric characteristics at room temperature | | | Max. d31 (0-200 °C) | Curie temp. (°C) |
|---|---|---|---|---|---|---|---|---|---|---|---|---|---|---|
| | x | y | z | w | | | | | | d31 Pm/ V) | k$_p$ | g31 X10$^{-3}$ (Vm/N) | | |
| Comp. Ex.7 | 0.22 | 0.50 | 0.10 | 0.02 | 5 | 1050 | 1 | 0 | 53 | 29.9 | 0.171 | 3.2 | - | - |
| Comp. Ex.8 | 0.02 | 0.50 | 0.45 | 0.02 | 5 | 1200 | 1 | 35 | 89 | 107.1 | 0.469 | 6.4 | - | 117 |
| Comp. Ex.9 | 0.02 | 0.50 | 0.10 | 0.22 | 5 | 1150 | 1 | 0 | 79 | 17.1 | 0.074 | 8.7 | - | - |
| Comp. Ex.10 | 0.22 | 0.50 | 0.45 | 0.22 | 5 | 1225 | 1 | 0 | 73 | 4.2 | 0.030 | 7.2 | - | - |

In addition, Figs. 1, 2 and 3(a) and 3(b) are x-ray diffraction patterns measured for the plane parallel to the tape surface of the crystal oriented ceramics obtained in Examples 1, 3 and 8 and the non-oriented sintered compact obtained in comparative Example 3, respectively. According to Figs. 1 through 3, in the crystal oriented ceramics obtained in Examples 1, 3 and 8, the pseudo-cubic {100} plane can be seen to be oriented to an extremely high degree of orientation.

In addition, Fig. 4 shows the temperature dependency of the piezoelectric $d_{31}$ constant of the crystal oriented ceramics obtained in Example 2 and the non-oriented sintered compact obtained in Comparative Example 1. In addition, Fig. 5 shows the temperature dependency of the piezoelectric $d_{31}$ constant of the crystal oriented ceramics obtained in Example 7 and the non-oriented sintered compact obtained in Comparative Example 3. Moreover, Fig. 6 shows the temperature dependency of the piezoelectric $d_{31}$ constant of the crystal oriented ceramics obtained in Example 9 and the non-oriented sintered compact obtained in Comparative Example 6. According to Figs. 4 through 6, the piezoelectric $d_{31}$ constant can be seen to improve at all temperatures as a result of orienting the pseudo-cubic {100} plane of each crystal grain that composes the polycrystalline substance in one direction.

Figs. 8 and 9 respectively indicate $D_{33large}$ and $E_{33large}$ in the case of driving by applying an electric field strength of 0-2000 V/mm in the form of a chopping wave having a frequency of 1 Hz over a temperature range of - 42 to 165°C to the crystal oriented ceramics obtained in Example 9 and Comparative Example 6 and to the non-oriented sintered compact obtained in Comparative Example 6. In addition, Tables 3 and 4 indicate the amounts of fluctuation over a prescribed temperature range of $D_{33large}$ and $E_{33large}$ in the case of driving by applying a high voltage (electric field strength: 0-2000 V/mm) in the form of a chopping wave having a frequency of 1 Hz over a temperature range of -42 to 165°C to the crystal oriented ceramics obtained in Example 9 and Comparative Example 6. In addition, Tables 3 and 4 also indicate the amounts of fluctuation for the sintered bodies produced in Example 22 (electric field strength: 0-1500 V/mm) and Example 23 (electric field strength: 0-2000 V/mm).

Moreover, Figs. 10 and 11 show the temperature characteristics of $D_{33large}/ (E_{33large})^{1/2}$ and $D_{33large}/E_{33large}$ in the case of driving the crystal oriented ceramics obtained in Example 9 and Comparative Example 6 by applying a high voltage (electric field strength: 0-2000 V/mm) in the form of a chopping wave having a frequency of 1 Hz over a temperature range of -42 to 165°C. In addition, Tables 5 and 6 show the amounts of fluctuation of $D_{33large} / (E33large)^{1/2}$ and $D_{33large}/E_{33large}$ over a prescribed temperature range in the case of driving by applying a high voltage (electric field strength: 0-2000 V/mm) in the form of a chopping wave having a frequency of 1 Hz over a temperature range of -40 to 165°C.

It can be understood from Fig. 8 and Table 3 that by orienting the pseudo-cubic {100} plane of each crystal grain that composes a polycrystalline substance in one direction, crystal oriented ceramics is obtained in which the amounts of fluctuation from the average value of the maximum and minimum values of $D_{33large}$ and $E_{33large}$ over an arbitrary temperature range of 100°C or more from -42°C to 165°C are within $\pm20\%$ and within $\pm15\%$, respectively, and superior temperature characteristics are expressed in comparison with a non-oriented sintered compact. In addition, the amount of fluctuation of $D_{33large}$ according to temperature was smaller in the crystal phase region of a tetragonal crystal at about 20°C or more than the crystal phase region of a rhombic crystal at about 20°C or more.

Moreover, it can be understood from Figs. 8, 10 and 11 and Tables 3, 5 and 6 that by orienting the pseudo-cubic {100} plane of each crystal grain that composes a polycrystalline substance in a single direction, the amounts of fluctuation of displacement in the case of constant voltage driving (characteristic index: $D_{33large}$), constant energy driving (characteristic index: $D_{33large}/(E_{33large})^{1/2}$) and constant charge driving (characteristic index: $D_{33large}/E_{33large}$) over an arbitrary temperature range of 100°C or more from -40°C to 165°C were demonstrated to be within $\pm20\%$, within $\pm10\%$ and within $\pm9\%$, respectively, and in any of these driving methods, superior temperature characteristics, in which the amount of fluctuation of displacement with respect to temperature is small, and easily controllable characteristics, are expressed in comparison with a non-oriented sintered compact.

Table 3

| | Composition | | | | Temp. range (°C) | Temp. margin (°C) | $D_{33large}$ | | | |
|---|---|---|---|---|---|---|---|---|---|---|
| | x | y | z | w | | | Max. (pm/V) | Min. (pm/V) | Avg. (pm/V) | Amt. of fluctuation |
| Ex.9 | 0.04 | 0.54 | 0.10 | 0.06 | -42-66°C | 108 | 775 | 380 | 578 | ±34 |
| | | | | | -17-86°C | 103 | 800 | 440 | 620 | ±29 |
| | | | | | 0.5-96°C | 96 | 800 | 550 | 675 | ±18 |
| | | | | | 24-127°C | 103 | 800 | 750 | 775 | ±3.2 |
| | | | | | 53-162°C | 109 | 800 | 750 | 775 | ±3.2 |
| | | | | | 66-162°C | 96 | 800 | 775 | 788 | ±1.6 |
| | | | | | 24-162°C | 138 | 800 | 750 | 775 | ±3.2 |
| Ex.22 | 0.08 | 0.5 | 0.10 | 0.06 | -40-70°C | 110 | 332 | 287 | 305 | ±5.7 |
| | | | | | -10-120°C | 103 | 307 | 287 | 297 | ±3.4 |
| | | | | | 20-120°C | 100 | 300 | 287 | 294 | ±2.4 |
| | | | | | 70-160°C | 90 | 326 | 289 | 308 | ±6.0 |
| | | | | | -40-160°C | 200 | 326 | 287 | 307 | ±6.4 |
| Ex.23 | 0.07 | 0.57 | 0.09 | 0.07 | -40-82°C | 122 | 671 | 503 | 587 | ±14 |
| | | | | | -30-82°C | 112 | 671 | 650 | 660 | ±1.6 |
| | | | | | -11-82°C | 93 | 671 | 650 | 660 | ±1.6 |
| | | | | | 22-161°C | 139 | 692 | 650 | 671 | ±3.1 |
| | | | | | -30-162°C | 192 | 692 | 650 | 671 | ±3.1 |
| Comp. Ex.6 | 0.04 | 0.54 | 0.10 | 0.06 | -42-52°C | 94 | 525 | 235 | 380 | ±38 |
| | | | | | -20-96°C | 116 | 525 | 260 | 393 | ±34 |
| | | | | | 0-96°C | 96 | 525 | 310 | 418 | ±26 |
| | | | | | 52-165°C | 113 | 450 | 363 | 363 | ±24 |

Table 4

| | Composition | | | | Temp. range (°C) | Temp. margin (°C) | $E_{33large}$ | | | |
|---|---|---|---|---|---|---|---|---|---|---|
| | x | y | z | w | | | Max. | Min. | Avg. | Amt. of fluctuation |
| Ex.9 | 0.04 | 0.54 | 0.10 | 0.06 | -42-66°c | 108 | 2824 | 1186 | 2005 | ±41 |
| | | | | | -17-86°C | 103 | 2824 | 1271 | 2047 | ±38 |
| | | | | | 0.5-96°C | 96 | 2824 | 1751 | 2287 | ±24 |
| | | | | | 29-127°C | 103 | 3106 | 2824 | 2965 | ±4.8 |
| | | | | | 53-162°C | 109 | 3219 | 2824 | 3021 | ±6.5 |
| | | | | | 66-162°C | 96 | 3219 | 2824 | 3021 | ±6.5 |
| | | | | | 24-162°C | 138 | 3219 | 2824 | 3021 | ±6.5 |

(continued)

| | Composition | | | | Temp. range (°C) | Temp. margin (°C) | E<sub>33large</sub> | | | |
|---|---|---|---|---|---|---|---|---|---|---|
| | x | y | z | w | | | Max. | Min. | Avg. | Amt. of fluctuation |
| Ex.22 | 0.08 | 0.5 | 0.10 | 0.06 | -40-70°C | 110 | 1620 | 1444 | 1532 | ±5.7 |
| | | | | | -10-120°C | 103 | 2200 | 1444 | 1822 | ±21 |
| | | | | | 20-120°C | 100 | 2200 | 1444 | 1822 | ±21 |
| | | | | | 70-160°C | 90 | 2657 | 1620 | 2139 | ±24 |
| | | | | | 40-160°C | 200 | 2657 | 1444 | 2051 | ±30 |
| Ex.23 | 0.07 | 0.57 | 0.09 | 0.07 | -40-82°C | 122 | 2428 | 1835 | 2132 | ±14 |
| | | | | | -30-82°C | 112 | 2428 | 2315 | 2372 | ±2.4 |
| | | | | | -11-82°C | 93 | 2428 | 2315 | 2372 | ±2.4 |
| | | | | | 22-161°C | 139 | 2429 | 2315 | 2372 | ±2.4 |
| | | | | | -30-162°C | 192 | 2429 | 2315 | 2372 | ±2.4 |
| Comp. Ex.6 | 0.04 | 0.54 | 0.10 | 0.06 | -42-52°C | 94 | 2993 | 1016 | 2005 | ±49 |
| | | | | | -20-96°C | 116 | 2993 | 1129 | 2061 | ±45 |
| | | | | | 0-96°C | 96 | 2993 | 1412 | 2202 | ±36 |
| | | | | | 52-165°C | 113 | 2711 | 1995 | 2353 | ±15.2 |

Table 5

| | Composition | | | | Temp. range (°C) | Temp. margin (°C) | $D_{33large}/(E_{33large})^{1/2}$ | | | |
|---|---|---|---|---|---|---|---|---|---|---|
| | x | y | z | w | | | Max. (pm/V) | Min. (pm/V) | Avg. (pm/V) | Amt. of fluctuation |
| Ex.9 | 0.04 | 0.54 | 0.10 | 0.06 | -42-66°C | 108 | 14.58 | 11.03 | 12.81 | ±14 |
| | | | | | -17-86°C | 103 | 15.06 | 12.34 | 13.70 | ±9.9 |
| | | | | | 0.5-96°C | 96 | 15.06 | 13.15 | 14.10 | ±6.8 |
| | | | | | 24-127°C | 103 | 15.06 | 14.11 | 14.58 | ±3.2 |
| | | | | | 53-162'C | 109 | 15.06 | 14.10 | 14.58 | ±3.3 |
| | | | | | 66-162°C | 96 | 15.06 | 14.10 | 14.58 | ±3.3 |
| | | | | | 24-162°C | 138 | 15.06 | 14.10 | 14.58 | ±3.3 |
| Ex.22 | 0.08 | 0.5 | 0.10 | 0.06 | -40-70°C | 110 | 8.28 | 7.18 | 7.73 | ±7.1 |
| | | | | | -10-120°C | 103 | 8.07 | 6.40 | 7.23 | ±12 |
| | | | | | 20-120°C | 100 | 7.55 | 6.40 | 6.97 | ±8.3 |
| | | | | | 70-160°C | 90 | 7.18 | 6.32 | 6.75 | ±6.3 |
| | | | | | -40-160°C | 200 | 8.28 | 6.32 | 7.30 | ±13 |

(continued)

| | Composition | | | | Temp. range (°C) | Temp. margin (°C) | $D_{33large}/(E_{33large})^{1/2}$ | | | |
|---|---|---|---|---|---|---|---|---|---|---|
| | x | y | z | w | | | Max. (pm/V) | Min. (pm/V) | Avg. (pm/V) | Amt. of fluctuation |
| Ex.23 | 0.07 | 0.57 | 0.09 | 0.07 | -40-82°C | 122 | 13.70 | 11.75 | 12.72 | ±7.7 |
| | | | | | -30-82°C | 112 | 13.70 | 13.27 | 13.48 | ±1.6 |
| | | | | | -11-82°C | 93 | 13.70 | 13.31 | 13.50 | ±1.4 |
| | | | | | 22-161°C | 139 | 14.04 | 13.51 | 13.77 | ±1.9 |
| | | | | | -30-162°C | 192 | 14.04 | 13.27 | 13.65 | ±2.8 |
| Comp. Ex.6 | 0.04 | 0.54 | 0.10 | 0.06 | -42-52°C | 94 | 9.60 | 7.37 | 8.48 | ±13 |
| | | | | | -20-96°C | 116 | 9.60 | 7.56 | 8.58 | ±12 |
| | | | | | 0-96°C | 96 | 9.60 | 7.56 | 8.58 | ±12 |
| | | | | | 52-165°C | 113 | 8.64 | 6.16 | 7.40 | ±17 |

Table 6

| | Composition | | | | Temp. range (°C) | Temp. margin (°C) | $D_{33large}/E_{33large}$ | | | |
|---|---|---|---|---|---|---|---|---|---|---|
| | x | y | z | w | | | Max. (pm/V) | Min. (pm/V) | Avg. (pm/V) | Amt. of fluctuation |
| Ex.9 | 0.04 | 0.54 | 0.10 | 0.06 | -42-66°C | 108 | 0.3463 | 0.2656 | 0.3060 | ±13 |
| | | | | | -17-86°C | 103 | 0.3463 | 0.2656 | 0.3060 | ±13 |
| | | | | | 0.5-96°C | 96 | 0.3142 | 0.2656 | 0.2899 | ±8.4 |
| | | | | | 24-127°C | 103 | 0.2833 | 0.2485 | 0.2704 | ±4.8 |
| | | | | | 53-162°C | 109 | 0.2833 | 0.2485 | 0.2659 | ±6.5 |
| | | | | | 66-162°C | 96 | 0.2833 | 0.2485 | 0.2659 | ±6.5 |
| | | | | | 24-162°C | 138 | 0.2833 | 0.2485 | 0.2659 | ±6.5 |
| Ex.22 | 0.08 | 0.5 | 0.10 | 0.06 | -40-70°C | 110 | 0.2130 | 0.1784 | 0.1957 | ±8.8 |
| | | | | | -10-120°C | 103 | 0.2120 | 0.1364 | 0.1742 | ±22 |
| | | | | | 20-120°C | 100 | 0.1988 | 0.1364 | 0.1676 | ±19 |
| | | | | | 70-160°C | 90 | 0.1784 | 0.1227 | 0.1505 | ±19 |
| | | | | | -40-160°C | 200 | 0.2130 | 0.1227 | 0.1678 | ±27 |
| Ex.23 | 0.07 | 0.57 | 0.09 | 0.07 | -40-82°C | 122 | 0.2808 | 0.2708 | 0.2758 | ±1.8 |
| | | | | | -30-82°C | 112 | 0.2808 | 0.2708 | 0.2758 | ±1.8 |
| | | | | | -11-82°C | 93 | 0.2808 | 0.2725 | 0.2766 | ±1.5 |
| | | | | | 22-161°C | 139 | 0.2849 | 0.2763 | 0.2806 | ±1.5 |
| | | | | | -30-162°C | 192 | 0.2849 | 0.2708 | 0.2778 | ±2.5 |

(continued)

| | Composition | | | | Temp. range (°C) | Temp. margin (°C) | $D_{33large}/E_{33large}$ | | | |
|---|---|---|---|---|---|---|---|---|---|---|
| | x | y | z | w | | | Max. (pm/V) | Min. (pm/V) | Avg. (pm/V) | Amt. of fluctuation |
| Comp. Ex.6 | 0.04 | 0.54 | 0.10 | 0.06 | -42-52°C | 94 | 0.2312 | 0.1660 | 0.1986 | ±16 |
| | | | | | -20-96°C | 116 | 0.2302 | 0.1631 | 0.1967 | ±17 |
| | | | | | 0-96°C | 96 | 0.2196 | 0.1631 | 0.1913 | ±15 |
| | | | | | 52-165°C | 113 | 0.1660 | 0.1378 | 0.1519 | ±9.3 |

Examples 10-21 and Comparative Examples 11-22

Sintered bodies were produced by preparing oriented raw materials in which plate-like NN template powder was blended at a ratio of 5 at% of the A site atoms of $ABO_3$ while varying the amount added y of Na in the composition $\{Li_{0.04} (K_{1-y}Na_y)_{0.96}\} \{Nb_{0.84}Ta_{0.10}Sb_{0.06}\}O_3$ (Examples 10-21), preparing non-oriented materials in which plate-like NN template powder was not used (Comparative Examples 11-22), and then hot pressing in oxygen the plate-like molded products after degreasing using a heating temperature of 1050-1200°C, heating time of 1 hour, temperature increase and decrease of 200°C/hour, and applying pressure of 35 kg/cm$^2$ (3.42 MPa) during the heating period.

Table 2 shows the blended compositions of Examples 10-21 and Comparative Examples 11-22. In addition, the blended compositions of the sintered compacts produced in Example 9 and Comparative Example 6 are also shown in Table 2.

Table 2

| | Composition | | | | Amt. Of NaNbO$_3$ template (at% [A site atomic ratio]) |
|---|---|---|---|---|---|
| | x | y | z | w | |
| Ex. 10 | 0.04 | 0 | 0.10 | 0.06 | 5 |
| Comp. Ex. 11 | | | | | 0 |
| Ex. 11 | 0.04 | 0.05 | 0.10 | 0.06 | 5 |
| Comp. Ex. 12 | | | | | 0 |
| Ex. 12 | 0.04 | 0.10 | 0.10 | 0.06 | 5 |
| Comp. Ex. 13 | | | | | 0 |
| Ex. 13 | 0.04 | 0.20 | 0.10 | 0.06 | 5 |
| Comp. Ex. 14 | | | | | 0 |
| Ex. 14 | 0.04 | 0.30 | 0.10 | 0.06 | 5 |
| Comp. Ex. 15 | | | | | 0 |
| Ex. 15 | 0.04 | 0.40 | 0.10 | 0.06 | 5 |
| Comp. Ex. 16 | | | | | 0 |
| Ex. 16 | 0.04 | 0.46 | 0.10 | 0.06 | 5 |
| Comp. Ex. 17 | | | | | 0 |
| Ex. 17 | 0.04 | 0.50 | 0.10 | 0.06 | 5 |
| Comp. Ex. 18 | | | | | 0 |
| Ex. 9 | 0.04 | 0.54 | 0.10 | 0.06 | 5 |
| Comp. Ex. 6 | | | | | 0 |

(continued)

| | Composition | | | | Amt. Of NaNbO$_3$ template (at% [A site atomic ratio]) |
|---|---|---|---|---|---|
| | x | y | z | w | |
| Ex. 18 | 0.04 | 0.60 | 0.10 | 0.06 | 5 |
| Comp. Ex. 19 | | | | | 0 |
| Ex. 19 | 0.04 | 0.70 | 0.10 | 0.06 | 5 |
| Comp. Ex. 20 | | | | | 0 |
| Ex. 20 | 0.04 | 0.75 | 0.10 | 0.06 | 5 |
| Comp. Ex. 21 | | | | | 0 |
| Ex. 21 | 0.04 | 0.80 | 0.10 | 0.06 | 5 |
| Comp. Ex. 22 | | | | | 0 |

The resulting sintered compacts were evaluated for sintered compact density, average degree of orientation and piezoelectric characteristics using the same procedures as described in Example 1. The relative densities of the sintered compacts obtained in Examples 10-21 and Comparative Examples 11-22 were all 95% or more. In addition, the average degrees of orientation as measured according to the Lotgering method of the pseudo-cubic {100} plane with respect to a plane parallel to the tape surface were all 0% in the case of the non-oriented sintered compacts, but all 70% or more in the case of the oriented sintered compacts.

Fig. 7 shows the values of the piezoelectric d$_{31}$ constant measured at room temperature for Example 9 and Examples 10-21 as well as for Comparative Examples 5 and 6 and Comparative Examples 11-22. As shown in Fig. 7, improvements of 1.2 times or more in characteristics in terms of the d$_{31}$ constant of the oriented sintered bodies were observed as compared with non-oriented sintered compacts of the same composition. According to Fig. 7, in a composition in which x = 0.04, z = 0.1 and w = 0.06, if y is within the range of 0.2 to 0.7, crystal oriented ceramics are obtained in which the piezoelectric d$_{31}$ constant at room temperature is 70 pm/V or more, and if y is within the range of 0.4 to 0.6, crystal oriented ceramics are obtained in which the piezoelectric d$_{31}$ constant at room temperature is 120 pm/V or more.

Example 22

Fig. 12 shows D$_{33large}$ in the case of producing an actuator with the crystal oriented ceramics obtained in Example 22 and driving by applying a high voltage of an electric field strength of 0-1500 V/mm in the form of a sine wave having a frequency of 1 Hz over a temperature range of -40 to 161°C. In addition, Tables 3 and 4 show the amounts of fluctuation of D$_{33large}$ and E$_{33large}$ in Example 22 at that time. It can be understood from Fig. 10 and Tables 3 and 4 that crystal oriented ceramics having superior temperature characteristics are obtained in which the amounts of fluctuation of the average value of the maximum value and minimum value of D$_{33large}$ and E$_{33large}$ over an arbitrary temperature range of 100°C or more from - 40°C to 161°C are within ±20% and within ±15%, respectively, by orienting the pseudo-cubic {100} plane of each crystal grain that composes the polycrystalline substance in a single direction.

In addition, Tables 5 and 6 show the amounts of fluctuation over a predetermined temperature range of D$_{33large}$/(E$_{33large}$)$^{1/2}$ and D$_{33large}$/E$_{33large}$ in the case of driving by applying a high voltage (electric field strength: 0-2000 V/mm) in the form a sine wave having a frequency of 1 Hz over a temperature range of -40°C to 161°C.

It can be understood from Fig. 12 and Tables 3, 5 and 6 that by orienting the pseudo-cubic {100} plane of each crystal grain that composes a polycrystalline substance in a single direction, the amounts of fluctuation of displacement in the case of constant voltage driving (characteristic index: D$_{33large}$), constant energy driving (characteristic index: D$_{33large}$/(E$_{33large}$)$^{1/2}$) and constant charge driving (characteristic index: D$_{33large}$/E$_{33large}$) over an arbitrary temperature range of 100°C or more from -40°C to 161°C were demonstrated to be within ±20%, within ±10% and within ±9%, respectively, and in any of these driving methods, superior temperature characteristics, in which the amount of fluctuation of displacement with respect to temperature is small, and easily controllable characteristics, are expressed.

Example 23

Fig. 13 shows D$_{33large}$ in the case of driving the crystal oriented ceramics obtained in Example 23 by applying a high voltage of an electric field strength of 0-2000 V/mm in the form of a chopping wave having a frequency of 1 Hz over a temperature range of -40 to 161°C. In addition, Tables 3 and 4 show the amounts of fluctuation of D$_{33large}$ and E$_{33large}$ in Example 23 at that time.

It can be understood from Fig. 13 and Tables 3 and 4 that crystal oriented ceramics having superior temperature characteristics are obtained in which the amounts of fluctuation of the average value of the maximum value and minimum value of $D_{33large}$ and $E_{33large}$ over an arbitrary temperature range of 100°C or more from -40°C to 161°C are within $\pm20\%$ and within $\pm15\%$, respectively, by orienting the pseudo-cubic {100} plane of each crystal grain that composes the polycrystalline substance in a single direction.

In addition, Fig. 14 shows the results of calculating the temperature characteristics of displacement in the case of constant voltage driving (characteristic index: $D_{33large}$), constant energy driving (characteristic index: $D_{33large}/(E_{33large})^{1/2}$ and constant charge driving (characteristic index: $D_{33large}/E_{33large}$) using displacement at room temperature as a reference value (100%). In addition, Tables 5 and 6 show the amounts of fluctuation over a predetermined temperature range of $D_{33large}/(E33_{large})^{1/2}$ and $D_{33large}/E_{33large}$ in the case of driving by applying a high voltage (electric field strength: 0-2000 V/mm) in the form a chopping wave having a frequency of 1 Hz over a temperature range of -40°C to 161°C. It can be understood from Fig. 14 and Tables 3, 5 and 6 that by orienting the pseudo-cubic {100} plane of each crystal grain that composes a polycrystalline substance in a single direction, the amounts of fluctuation from the average value of the maximum value and minimum value of $D_{33large}$, $D_{33large}/(E_{33large})^{1/2}$ and $D_{33large}/E_{33large}$) over an arbitrary temperature range of 100°C or more from -40°C to 161°C were demonstrated to be within $\pm20\%$, within $\pm10\%$ and within $\pm9\%$, respectively, and in any of these driving methods, superior temperature characteristics, in which the amount of fluctuation of displacement with respect to temperature is small, and easily controllable characteristics, are expressed.

Moreover, as a result of measuring the temperature dependency (temperature range: -30 to 161°C) of displacement in the case of driving by making the injection energy (W) constant (constant energy driving) and the injection charge (Q) constant (constant charge driving), superior temperature characteristics similar to the results of Fig. 14 were demonstrated in which the amount of fluctuation of displacement with respect to temperature is small.

Moreover, Figs. 15 and 16 respectively show the generated displacement and generated electric field in the case of driving the crystal oriented ceramics obtained in Example 23 at a constant injection energy (W) (constant energy driving) over a temperature range of -40 to 161°C. In addition, Tables 7 and 8 show the amounts of fluctuation of the generated displacement and generated electric field at that time. It can be understood from Figs. 15 and 16 and Tables 7 and 8 that by orienting the pseudo-cubic {100} plane of each crystal grain that composes a polycrystalline substance in a single direction, the amounts of fluctuation of from the average value of the maximum value and minimum value of generated displacement and generated electric field over an arbitrary temperature range of 100°C or more from -40°C to 161°C were demonstrated to be within $\pm10\%$ and within $\pm15\%$, respectively, demonstrating superior temperature characteristics in which the amounts of fluctuation of generated displacement and generated electric field with respect to temperature are small.

Moreover, Figs. 17 and 18 respectively show the generated displacement and generated electric field in the case of driving the crystal oriented ceramics obtained in Example 23 at a constant injection charge (Q) (constant charge driving) over a temperature range of -40 to 161°C. In addition, Tables 9 and 10 show the amounts of fluctuation of the generated displacement and generated electric field at that time. It can be understood from Figs. 17 and 18 and Tables 9 and 10 that by orienting the pseudo-cubic {100} plane of each crystal grain that composes a polycrystalline substance in a single direction, the amounts of fluctuation of from the average value of the maximum value and minimum value of generated displacement and generated electric field over an arbitrary temperature range of 100°C or more from - 40°C to 161°C were demonstrated to be within $\pm9\%$ and within $\pm15\%$, respectively, demonstrating superior temperature characteristics in which the amounts of fluctuation of generated displacement and generated electric field with respect to temperature are small.

Table 7

| Injection Energy (J/m$^3$) | Temperature Range (°C) | Temperature Margin (°C) | Displacement | | | |
|---|---|---|---|---|---|---|
| | | | Max. (ppm) | Min. (ppm) | Avg. (ppm) | Amt. of fluctuation (4) |
| 10000 | -40-82°C | 122 | 570 | 470 | 520 | $\pm9.6$ |
| | -30-82°C | 112 | 570 | 500 | 535 | $\pm6.5$ |
| | -11-82°C | 93 | 570 | 520 | 545 | $\pm4.6$ |
| | 22-161°C | 139 | 570 | 510 | 540 | $\pm5.6$ |
| | -30-161°C | 191 | 570 | 500 | 535 | $\pm6.5$ |

(continued)

| Injection Energy (J/m$^3$) | Temperature Range (°C) | Temperature Margin (°C) | Displacement | | | |
|---|---|---|---|---|---|---|
| | | | Max. (ppm) | Min. (ppm) | Avg. (ppm) | Amt. of fluctuation (4) |
| 20000 | -40-82°C | 122 | 930 | 800 | 865 | ±7.5 |
| | -30-82°C | 112 | 930 | 830 | 880 | ±5.7 |
| | -11-82°C | 93 | 930 | 830 | 880 | ±5.7 |
| | 22-161°C | 139 | 960 | 830 | 895 | ±7.3 |
| | -30-161°C | 191 | 960 | 830 | 895 | ±7.3 |
| 30000 | -40-82°C | 122 | 1200 | 1090 | 1145 | ±4.8 |
| | -30-82°C | 112 | 1200 | 1160 | 1180 | ±1.7 |
| | -11-82°C | 93 | 1200 | 1160 | 1180 | ±1.7 |
| | 22-161°C | 139 | 1250 | 1160 | 1205 | ±3.7 |
| | -30-161°C | 191 | 1250 | 1160 | 1205 | ±3.7 |

Table 8

| Injection Energy (J/m$^3$) | Temperature Range (°C) | Temperature Margin (°C) | Electric Field | | | |
|---|---|---|---|---|---|---|
| | | | Max. (V/mm) | Min. (V/mm) | Avg. (V/mm) | Amt. of fluctuation (%) |
| 10000 | -40-82°C | 122 | 1130 | 1040 | 1085 | ±4.1 |
| | -30-82°C | 112 | 1060 | 1040 | 1050 | ±1.0 |
| | -11-82°C | 93 | 1060 | 1060 | 1060 | ±0.0 |
| | 22-161°C | 139 | 1060 | 1000 | 1030 | ±2.9 |
| | -30-161°C | 191 | 1060 | 1000 | 1030 | ±2.9 |
| 20000 | -40-82°c | 122 | 1480 | 1420 | 1450 | ±2.1 |
| | -30-82°C | 112 | 1440 | 1420 | 1430 | ±0.7 |
| | -11-82°C | 93 | 1440 | 1420 | 1430 | ±0.7 |
| | 22-161°C | 139 | 1440 | 1400 | 1420 | ±1.4 |
| | -30-161'C | 191 | 1440 | 1400 | 1420 | ±1.4 |
| 30000 | -40-82°C | 122 | 1920 | 1670 | 1795 | ±7.0 |
| | -30-82°C | 112 | 1750 | 1670 | 1710 | ±2.3 |
| | -11-82°C | 93 | 1750 | 1700 | 1725 | ±1.4 |
| | 22-161°C | 139 | 1750 | 1660 | 1705 | ±2.6 |
| | -30-161°C | 191 | 1750 | 1660 | 1705 | ±2.6 |

Table 9

| Injection Charge (µc/cm²) | Temperature Range (°C) | Temperature Margin (°C) | Displacement | | | |
|---|---|---|---|---|---|---|
| | | | Max. (ppm) | Min. (ppm) | Avg. (ppm) | Amt. of fluctuation (%) |
| 1 | -40-82°C | 122 | 220 | 190 | 205 | ±7.3 |
| | -30-82°C | 112 | 215 | 190 | 203 | ±6.2 |
| | -11-82°C | 93 | 215 | 190 | 203 | ±6.2 |
| | 22-161°C | 139 | 210 | 180 | 195 | ±7.7 |
| | -30-161°C | 191 | 215 | 180 | 198 | ±8.9 |
| 2 | -40-82°C | 122 | 660 | 535 | 598 | ±10.5 |
| | -30-82°C | 112 | 600 | 535 | 568 | ±5.7 |
| | -11-82°C | 93 | 600 | 580 | 590 | ±1.7 |
| | 22-161°C | 139 | 600 | 55 | 575 | ±4.3 |
| | -30-161°C | 191 | 600 | 535 | 568 | ±5.7 |
| 3 | -40-82°C | 122 | 1030 | 900 | 965 | ±6.7 |
| | -30-82°C | 112 | 1000 | 900 | 950 | ±5.3 |
| | -11-82°C | 93 | 1000 | 950 | 975 | ±2.6 |
| | 22-161°C | 139 | 1020 | 950 | 985 | ±3.6 |
| | -30-161°C | 191 | 1020 | 900 | 960 | ±6.3 |

Table 10

| Injection Charge (µC/cm²) | Temperature Range (°C) | Temperature Margin (°C) | Electric Field | | | |
|---|---|---|---|---|---|---|
| | | | Max. (V/mm) | Min. (V/mm) | Avg. (V/mm) | Amt. of fluctuation (%) |
| 1 | -40-82°C | 122 | 720 | 590 | 655 | ±9.9 |
| | -30-82°C | 112 | 620 | 590 | 605 | ±2.5 |
| | -11-82°C | 93 | 620 | 600 | 610 | ±1.6 |
| | 22-161°C | 139 | 650 | 560 | 605 | ±7.4 |
| | -30-161°C | 191 | 650 | 560 | 605 | ±7.4 |
| 2 | -40-82°C | 122 | 1250 | 1040 | 1145 | ±9.2 |
| | -30-82°C | 112 | 1140 | 1040 | 1090 | ±4.6 |
| | -11-82°C | 93 | 1140 | 1070 | 1105 | ±3.2 |
| | 22-161°C | 139 | 1140 | 1020 | 1080 | ±5.6 |
| | -30-161°C | 191 | 1140 | 1020 | 1080 | ±5.6 |

(continued)

| Injection Charge ($\mu$C/cm$^2$) | Temperature Range (°C) | Temperature Margin (°C) | Electric Field | | | |
|---|---|---|---|---|---|---|
| | | | Max. (V/mm) | Min. (V/mm) | Avg. (V/mm) | Amt. of fluctuation (%) |
| 3 | -40-82°C | 122 | 1850 | 1460 | 1655 | $\pm$12 |
| | -30-82°C | 112 | 1550 | 1460 | 1505 | $\pm$3.0 |
| | -11-82°C | 93 | 1550 | 1470 | 1510 | $\pm$2.6 |
| | 22-161°C | 139 | 1550 | 1450 | 1500 | $\pm$3.3 |
| | -30-161°C | 191 | 1550 | 1450 | 1500 | $\pm$3.3 |

Although the above has provided a detailed explanation of modes for carrying out the present invention, the present invention is not limited to the aforementioned modes, but rather can be altered in various ways within a range that does not deviate from the gist of the present invention.

For example, although normal pressure sintering or hot pressing was used when producing the crystal oriented ceramics in the aforementioned examples, other sintering methods (such as HIP treatment) may be used.

In addition, although the first anisotropic shaped powder is particularly preferable as a reactive template for producing the crystal oriented ceramics as claimed in the present invention, the applications of the first anisotropic shaped powder as claimed in the present invention are not limited to this, but rather can also be used as a powder for piezoelectric rubber compound material.

Moreover, although the explanations of the aforementioned modes for carrying out the invention focused primarily on crystal oriented ceramics composed of a first KNN compound preferable as a piezoelectric material or dielectric material, and its production method, thermoelectric characteristics and ion conducting characteristics can be imparted if a suitable auxiliary component and/or secondary phase is added to the first KNN compound. Consequently, by applying the production method as claimed in the present invention, crystal oriented ceramics can also be produced that are preferable as thermoelectric materials and ion conducting materials.

Since the crystal oriented ceramics as claimed in the present invention are composed of a polycrystalline substance having for its primary phase a first KNN compound, and a specific crystal plane of each crystal grain that composes the polycrystalline substance is oriented, there is the effect of exhibiting better characteristics as compared with non-oriented ceramics having the same composition.

In addition, since the crystal oriented ceramics production method as claimed in the present invention uses as a reactive template a first anisotropic shaped powder having a growth plane that has lattice coherency with a specific crystal plane of a first KNN compound, there is the effect of obtaining crystal oriented ceramics in which a specific crystal plane is oriented both easily and inexpensively. In addition, by optimizing the compositions of the first anisotropic shaped powder and first reaction raw material, there is the effect of facilitating control of the composition of A site elements contained in the first KNN compound that composes the primary phase of crystal oriented ceramics.

The present invention provides crystal oriented ceramics, and a production method of the same, having a basic composition of isotropic perovskite-based potassium sodium niobate, demonstrating superior piezoelectric characteristics, and having a specific crystal plane oriented to a high degree of orientation. The crystal oriented ceramics as claimed in the present invention is composed of a polycrystalline substance of an isotropic perovskite compound represented by the general formula: $\{Li_x(K_{1-y}Na_y)_{1-x}\}\{Nb_{1-z-w}Ta_zSb_w\}O_3$ (wherein, $0 \leq x \leq 0.2$, $0 \leq y \leq 1$, $0 \leq z \leq 0.4$, $0 \leq w \leq 0.2$, $x + z + w > 0$), and a specific crystal plane of each crystal grain that composes said polycrystalline substance is oriented. Such crystal oriented ceramics are obtained by molding a mixture of a first anisotropic shaped powder, for which the growth plane has lattice coherency with a specific crystal plane of the isotropic perovskite compound to be produced, and a first reaction raw material, so that the first anisotropic shaped powder is oriented, followed by heating.

## Claims

1. Crystal oriented ceramics composed of a polycrystalline substance of an isotropic perovskite compound represented by the general formula: $\{Li_x(K_{1-y}Na_y)_{1-x}\}\{Nb_{1-z-w}Ta_zSb_w\}O_3$ (wherein, $0 \leq x \leq 0.2$, $0 \leq y \leq 1$, $0 \leq z \leq 0.4$, $0 \leq w \leq 0.2$, $x + z + w > 0$), and a specific crystal plane of each crystal grain that composes said polycrystalline substance is oriented, wherein, the degree of orientation of the pseudo-cubic {100} plane as determined according to the Lotgering method is 30% or more.

2. Crystal oriented ceramics according to claim 1 wherein, the piezoelectric $d_{31}$ constant at room temperature is 1.1 times or more that of a non-oriented sintered compact having the same composition.

3. Crystal oriented ceramics according to any of claim 1 or 2 wherein, the electromechanical coupling coefficient $k_p$ at room temperature is 1.1 times or more that of a non-oriented sintered compact having the same composition.

4. Crystal oriented ceramics according to any of claims 1 through 3 wherein, the piezoelectric $g_{31}$ constant at room temperature is 1.1 times or more that of a non-oriented sintered compact having the same composition.

5. Crystal oriented ceramics according to any of claims 1 through 4 wherein, the rate of improvement resulting from orientation in displacement generated under electric field driving conditions having a constant amplitude of an electric field strength of 100 V/mm or more at a predetermined temperature equal to or below the Curie temperature is 1.1 times.

6. Crystal oriented ceramics according to any of claims 1 through 5 wherein, there is a temperature range where the amount of fluctuation of displacement under electric field driving conditions having a constant amplitude of an electric field strength of 100 V/mm or more over an arbitrary temperature range of 100°C or more equal to or lower than the Curie temperature is within $\pm$ 20%.

7. Crystal oriented ceramics according to any of claims 1 through 6 wherein, there is a temperature range where the amount of fluctuation of $E_{33large}$ as measured according to formula A1 under electric field driving conditions having a constant amplitude of an electric field strength of 100 V/mm over an arbitrary temperature range of 100°C or more equal to or lower than the Curie temperature is within t15%; wherein, the amount of polarization is measured from a polarization-electric field hysteresis loop in the case of driving by applying a high voltage, and $E_{33large}$ is the dielectric constant in a strong electric field based on this (dynamic dielectric constant), and is defined by equation A1:

$$E_{33large} = P_{max}/(EF_{max} \times \varepsilon_0) = (Q_{max}/A)/(V/L) \times \varepsilon_0) \quad A1$$

(wherein, Here, $P_{max}$ represents the maximum charge density (C/m$^2$), $EF_{max}$ represents the maximum electric field strength (V/m), $Q_{max}$ represents the maximum charge (C), A represents the electrode surface area (m$^2$), epsilon 0 represents the dielectric constant in a vacuum (F/m), L represents the original length prior to applying a voltage (m), and V represents the applied voltage (V)).

8. Crystal oriented ceramics according to any of claims 1 through 7 wherein, there is a temperature range where the amount of fluctuation of the value defined by $D_{33large}/(E_{33large})^{1/2}$ under electric field driving conditions having a constant amplitude over an arbitrary temperature range of 100°C or more equal to or lower than the Curie temperature is within $\pm 10\%$; wherein, $D_{33large}$ is the displacement generated in a direction parallel to the direction in which voltage is applied in the case of applying a high voltage, and is defined by equation A2:

$$D_{33large} = S_{max}/EF_{max} = (\Delta L/L)/(V/L) \quad A2$$

(wherein, $S_{max}$ represents the maximum strain, $\Delta L$ represents the displacement induced by the electric field (m), L represents the original length prior to applying a voltage (m), and V represents the applied voltage (V)).

9. Crystal oriented ceramics according to any of claims 1 through 8 wherein, there is a temperature range where the amount of fluctuation of the value defined by $D_{33large}/E_{33large}$ under electric field driving conditions having a constant amplitude over an arbitrary temperature range of 100°C or more equal to or lower than the Curie temperature is within $\pm 9\%$.

10. Crystal oriented ceramics according to any of claims 1 through 9 wherein, there is a temperature range where the amount of fluctuation of displacement generated under constant energy driving conditions over an arbitrary temperature range of 100°C or more equal to or lower than the Curie temperature is within ±10%.

11. Crystal oriented ceramics according to any of claims 1 through 10 wherein, there is a temperature range where the amount of fluctuation of displacement generated under constant charge driving conditions over an arbitrary temperature range of 100°C or more equal to or lower than the Curie temperature is within ±9%.

12. Crystal oriented ceramics according to any of claims 1 through 11 wherein, the crystal system is a tetragonal system over an arbitrary temperature range of 100°C or more equal to or lower than the Curie temperature.

13. A production method of crystal oriented ceramics comprising:

a mixing step in which a first anisotropic shaped powder, for which the growth plane has lattice coherency with a specific crystal plane of the isotropic perovskite compound according to claim 1, is mixed with a first reaction raw material that reacts with said first anisotropic shaped powder and at least forms the isotropic perovskite compound;
a molding step in which the mixture obtained in the mixing step is molded so that the first anisotropic shaped powder is oriented; and,
a heat treatment step in which the molded product obtained in the molding step is heated to cause a reaction between the first anisotropic shaped powder and the first reaction raw material.

14. A crystal oriented ceramics production method according to claim 13 wherein, the first anisotropic shaped powder is a plate-like powder having the pseudo-cubic {100} plane for its growth plane and is represented by the following general formula: -$(Li_x(K_{1-y}Na_x)_{1-x})\{Nb_{1-z-w}Ta_zSb_w\}O_3$ (wherein, x, y, z and w are $0 \leq x \leq 1$, $0 \leq y \leq 1$, $0 \leq z \leq 1$ and $0 \leq w \leq 1$, respectively).

15. A piezoelectric element comprised of a piezoelectric material composed of crystal oriented ceramics according to any of claims 1 through 12.

16. A dielectric element comprised of a dielectric material composed of crystal oriented ceramics according to any of claims 1 through 12.

17. A thermoelectric conversion element comprised of a thermoelectric conversion material composed of crystal oriented ceramics according to any of claims 1 through 12.

18. An ion conducting element comprised of an ion conducting material composed of crystal oriented ceramics according to any of claims 1 through 12.

**Patentansprüche**

1. Kristallorientierte Keramik, die aus einer polykristallinen Substanz aus einer isotropen Perovskitverbindung, die durch die allgemeine Formel: $\{Li_x(K_{1-y}Na_y)_{1-x}\}\{Nb_{1-z-w}Ta_zSb_w\}O_3$ (wobei $0 \leq x \leq 0,2$, $0 \leq y \leq 1$, $0 \leq z \leq 0,4$, $0 \leq w \leq 0,2$, $x + z + w > 0$) dargestellt ist, aufgebaut ist, und eine spezifische Kristallebene jedes Kristallkorns, das die polykristalline Substanz aufbaut, orientiert ist, wobei der Grad an Orientierung der pseudokubischen {100} Ebene, wie gemäß dem Lotgering-Verfahren bestimmt, 30% oder mehr beträgt.

2. Kristallorientierte Keramik nach Anspruch 1, wobei die piezoelektrische $d_{31}$ Konstante bei Raumtemperatur das 1,1-fache oder mehr der eines nicht orientierten gesinterten Kompaktstoffs mit derselben Zusammensetzung beträgt.

3. Kristallorientierte Keramik nach Anspruch 1 oder 2, wobei der elektromechanische Kupplungskoeffizient kp bei Raumtemperatur das 1,1-fache oder mehr des eines nicht orientierten gesinterten Kompaktstoffs mit derselben Zusammensetzung beträgt.

4. Kristallorientierte Keramik nach einem der Ansprüche 1 bis 3, wobei die piezoelektrische $g_{31}$ Konstante bei Raumtemperatur das 1,1-fache oder mehr der eines nicht orientierten gesinterten Kompaktstoffs mit derselben Zusammensetzung beträgt.

5. Kristallorientierte Keramik nach einem der Ansprüche 1 bis 4, wobei die Verbesserungsrate, die sich aus Orientierung

EP 1 457 471 B1

ergibt, bei Verschiebung, die unter Betriebsbedingungen elektrischen Feldes mit einer konstanten Amplitude einer elektrischen Feldstärke von 100 V/mm oder mehr gleich oder geringer als die Curie-Temperatur erzeugt wird, das 1,1-fache ist.

6. Kristallorientierte Keramik nach einem der Ansprüche 1 bis 5, wobei es einen Temperaturbereich gibt, wo die Menge an Fluktuation der Verschiebung unter Betriebsbedingungen elektrischen Feldes mit einer konstanten Amplitude einer elektrischen Feldstärke von 100 V/mm oder mehr oberhalb eines beliebigen Temperaturbereichs von 100°C oder mehr bei einer vorbestimmten Temperatur gleich oder geringer als die Curie-Temperatur innerhalb $\pm20\%$ liegt.

7. Kristallorientierte Keramik nach einem der Ansprüche 1 bis 6, wobei es einen Temperaturbereich gibt, wo die Menge an Fluktuation von $E_{33larger}$, wie gemäß der Formel A1 unter Betriebsbedingungen elektrischen Feldes mit einer konstanten Amplitude einer elektrischen Feldstärke von 100 V/mm über einen beliebigen Temperaturbereich von 100°C oder mehr gleich oder geringer als die Curie-Temperatur innerhalb $\pm15\%$ liegt; wobei die Menge an Polarisation aus einer Polarisation - elektrisches Feld Hystereseschleife in dem Fall gemessen wird, in dem durch Anlegen einer Hochspannung betrieben wird, und $E_{33large}$ die dielektrische Konstante in einem starken elektrischen Feld darauf basierend ist (dynamische Dielektrizitätskonstante), und durch die Gleichung A1 definiert ist:

$$E_{33large} = P_{max}/(EF_{max} \times \varepsilon_0) = (Q_{max}/A)/(V/L) \times \varepsilon_0) \quad A1$$

(wobei hier $P_{max}$ die maximale Ladungsdichte (C/m$^2$) darstellt, $EF_{max}$ die maximale elektrische Feldstärke (V/m) darstellt, $Q_{max}$ die maximale Ladung (C) darstellt, A die Elektrodenoberfläche (m$^2$) darstellt, Epsilon 0 die Dielektrizitätskonstante in einem Vakuum (F/m) darstellt, L die originale Länge vor dem Anlegen der Spannung (m) darstellt, und V die angelegte Spannung (V) darstellt).

8. Kristallorientierte Keramik nach einem der Ansprüche 1 bis 7, wobei es einen Temperaturbereich gibt, wo die Menge an Fluktuation des Wertes, der durch $D_{33large}/(E_{33large})^{1/2}$ unter Betriebsbedingungen elektrischen Feldes mit einer konstanten Amplitude über einen beliebigen Temperaturbereich von 100°C oder mehr gleich oder geringer als die Curie-Temperatur innerhalb $\pm10\%$ liegt; wobei $D_{33large}$ die Verschiebung ist, die in einer Richtung parallel zu der Richtung, in welcher die Spannung angelegt wird, im Fall des Anlegens einer Hochspannung erzeugt wird und durch die Gleichung A2 definiert ist:

$$D_{33large} = S_{max}/EF_{max} = (\Delta L/L)/(V/L) \quad A2$$

(wobei $S_{max}$ die maximale Deformation darstellt, $\Delta L$ die durch das elektrische Feld induzierte Verschiebung (m) darstellt, L die originale Länge vor dem Anlegen der Spannung (m) darstellt, und V die angelegte Spannung (V) darstellt).

9. Kristallorientierte Keramik nach einem der Ansprüche 1 bis 8, wobei es einen Temperaturbereich gibt, wo die Menge der Fluktuation des Wertes, der durch $D_{33large}/E_{33large}$ definiert ist, unter Betriebsbedingungen elektrischen Feldes mit einer konstanten Amplitude oberhalb eines beliebigen Temperaturbereichs von 100°C oder mehr gleich oder geringer als die Curie-Temperatur innerhalb $\pm9\%$ liegt.

10. Kristallorientierte Keramik nach einem der Ansprüche 1 bis 9, wobei es einen Temperaturbereich gibt, wo die Menge an Fluktuation an Verschiebung, die unter konstant-Energie-Betriebsbedingungen über einen beliebigen Temperaturbereich von 100°C oder mehr gleich oder geringer als die Curie-Temperatur erzeugt wird, innerhalb $\pm10\%$ liegt.

11. Kristallorientierte Keramik nach einem der Ansprüche 1 bis 9, wobei es einen Temperaturbereich gibt, wo die Menge der Fluktuation an Verschiebung, die unter konstant-Ladung-Betriebsbedingungen über einen beliebigen Temperaturbereich von 100°C oder mehr gleich oder geringer als die Curie-Temperatur erzeugt wird, innerhalb $\pm9\%$ liegt.

12. Kristallorientierte Keramik nach einem der Ansprüche 1 bis 11, wobei das Kristallsystem über einem beliebigen Temperaturbereich von 100°C oder mehr gleich oder geringer als die Curie-Temperatur ein tetragonales System ist.

13. Herstellungsverfahren einer kristallorientierten Keramik, das umfasst:

einen Mischschritt, bei welchem ein erstes anisotrop geformtes Pulver, für welches die Wachstumsebene eine Gitterkohärenz mit einer spezifischen Kristallebene der isotropen Perovskitverbindung gemäß Anspruch 1 aufweist, mit einem ersten Reaktionsrohmaterial vermischt wird, das mit dem ersten anisotrop geformten Pulver reagiert und zumindest die isotrope Perovskitverbindung bildet;

einen Formungsschritt, bei welchem die in dem Mischschritt erhaltene Mischung so geformt wird, dass das erste anisotrop geformte Pulver orientiert wird; und,

einen Wärmebehandlungsschritt, bei welchem das in dem Formschritt erhaltene geformte Produkt erwärmt wird, um eine Reaktion zwischen dem ersten anisotrop geformten Pulver und dem ersten Reaktionsrohmaterial zu verursachen.

**14.** Herstellungsverfahren einer kristallorientierten Keramik nach Anspruch 13, wobei das erste anisotrop geformte Pulver ein plättchenartiges Pulver mit der pseudokubischen {100} Ebene für dessen Wachstumsebene ist und durch die folgende allgemeine Formel: $\{Li_x(K_{1-y}Na_x)_{1-x}\}\{Nb_{1-z-w}Ta_zSb_w\}O_3$ (wobei x, y, z und w jeweils $0 \leq x \leq 1$, $0 \leq y \leq 1$, $0 \leq z \leq 1$ bzw. $0 \leq w \leq 1$ ist) dargestellt ist.

**15.** Piezoelektrisches Element, das ein piezoelektrisches Material umfasst, das aus kristallorientierter Keramik nach einem der Ansprüche 1 bis 12 aufgebaut ist.

**16.** Dielektrisches Element, das ein dielektrisches Material umfasst, das aus kristallorientierter Keramik nach einem der Ansprüche 1 bis 12 aufgebaut ist.

**17.** Thermoelektrisches Umwandlungselement, das ein thermoelektrisches Umwandlungsmaterial umfasst, das aus kristallorientierter Keramik nach einem der Ansprüche 1 bis 12 aufgebaut ist.

**18.** Ionenleitendes Element, das ein ionenleitendes Material umfasst, das aus kristallorientierter Keramik nach einem der Ansprüche 1 bis 12 aufgebaut ist.

## Revendications

**1.** Céramique à orientation cristalline, composée d'une substance polycristalline d'un composé de pérovskite isotrope représenté par la formule générale :

$\{Li_x(K_{1-y}Na_y)_{1-x}\}\{Nb_{1-z-w}Ta_zSb_w\}O_3$ (où $0 \leq x \leq 0,2$, $0 \leq y \leq 1$, $0 \leq z \leq 0,4$, $0 \leq w \leq 0,2$, $x + z + w > 0$), et un plan cristallin spécifique de chaque grain cristallin qui compose ladite substance polycristalline est orienté, le degré d'orientation du plan pseudo-cubique {100} tel que déterminé selon la méthode de Lotgering étant supérieur ou égal à 30 %.

**2.** Céramique à orientation cristalline selon la revendication 1, dans laquelle la constante piézoélectrique $d_{31}$ à température ambiante est supérieure ou égale à 1,1 fois celle d'une pièce frittée non orientée possédant la même composition.

**3.** Céramique à orientation cristalline selon la revendication 1 ou 2, dans laquelle le coefficient de couplage électromécanique $k_p$ à température ambiante est supérieure ou égal à 1,1 fois celui d'une pièce frittée non orientée possédant la même composition.

**4.** Céramique à orientation cristalline selon l'une quelconque des revendications 1 à 3, dans laquelle la constante piézoélectrique $g_{31}$ à température ambiante est supérieure ou égale à 1,1 fois celle d'une pièce frittée non orientée possédant la même composition.

**5.** Céramique à orientation cristalline selon l'une quelconque des revendications 1 à 4, dans laquelle le taux d'amélioration résultant de l'orientation en termes de déplacement généré dans des conditions d'entraînement en champ électrique présentant une amplitude constante d'intensité de champ électrique supérieure ou égale à 100 V/mm à une température prédéterminée inférieure ou égale à la température de Curie est de 1,1 fois.

**6.** Céramique à orientation cristalline selon l'une quelconque des revendications 1 à 5, dans laquelle il existe une plage de températures dans laquelle la quantité de fluctuation du déplacement dans des conditions d'entraînement en champ électrique présentant une amplitude constante d'intensité de champ électrique supérieure ou égale à 100 V/mm sur une plage arbitraire de températures de 100 °C ou plus inférieure ou égale à la température de Curie est de ± 20 %.

7. Céramique à orientation cristalline selon l'une quelconque des revendications 1 à 6, dans laquelle il existe une plage de températures dans laquelle la quantité de fluctuation de $E_{33large}$, telle que mesurée selon la formule A1, dans des conditions d'entraînement en champ électrique présentant une amplitude constante d'intensité de champ électrique de 100 V/mm sur une plage arbitraire de températures de 100 °C ou plus inférieure ou égale à la température de Curie est de ± 15 % ; dans lequel la quantité de polarisation est mesurée à partir d'une boucle d'hystérésis polarisation-champ électrique dans le cas d'un entraînement effectué par l'application d'une tension élevée, et $E_{33large}$ est la constante diélectrique dans un champ électrique intense basée sur cette (constante diélectrique dynamique) et est définie par l'équation A1 :

$$E_{33large} = P_{max}/(EF_{max} \times \varepsilon_0) = (Q_{max}/A)(V/L) \times \varepsilon_0)\qquad A1$$

(où, ici, $P_{max}$ représente la densité de charge maximale ($C/m^2$), $EF_{max}$ représente l'intensité maximale du champ électrique (V/m), $Q_{max}$ représente la charge maximale (C), A représente la surface de l'électrode ($m^2$), epsilon 0 représente la constante diélectrique du vide (F/m), L représente la longueur d'origine avant l'application d'une tension (m) et V représente la tension appliquée (V)).

8. Céramique à orientation cristalline selon l'une quelconque des revendications 1 à 7, dans laquelle il existe une plage de températures dans laquelle la quantité de fluctuation de la valeur définie par $D_{33large}/(E_{33large})^{1/2}$ dans des conditions d'entraînement en champ électrique présentant une amplitude constante sur une plage arbitraire de températures de 100 °C ou plus inférieure ou égale à la température de Curie est de ± 10 % ; dans lequel $D_{33large}$ est le déplacement généré dans une direction parallèle à la direction dans laquelle une tension est appliquée dans le cas de l'application d'une tension élevée, et est définie par l'équation A2 :

$$D_{33large} = S_{max}/EF_{max} = (\Delta L/L)(V/L)\qquad A2$$

(où, $S_{max}$ représente la contrainte maximale, $\Delta L$ représente le déplacement induit par le champ électrique (m), L représente la longueur d'origine avant l'application d'une tension (m) et V représente la tension appliquée (V)).

9. Céramique à orientation cristalline selon l'une quelconque des revendications 1 à 8, dans laquelle il existe une plage de températures dans laquelle la quantité de fluctuation de la valeur définie par $D_{33large}/E_{33large}$ dans des conditions d'entraînement en champ électrique présentant une amplitude constante sur une plage arbitraire de températures de 100 °C ou plus inférieure ou égale à la température de Curie est de ± 9 %.

10. Céramique à orientation cristalline selon l'une quelconque des revendications 1 à 9, dans laquelle il existe une plage de températures dans laquelle la quantité de fluctuation du déplacement généré dans des conditions d'entraînement à énergie constante sur une plage arbitraire de températures de 100 °C ou plus inférieure ou égale à la température de Curie est de ± 10 %.

11. Céramique à orientation cristalline selon l'une quelconque des revendications 1 à 10, dans laquelle il existe une plage de températures dans laquelle la quantité de fluctuation du déplacement généré dans des conditions d'entraînement à charge constante sur une plage arbitraire de températures de 100 °C ou plus inférieure ou égale à la température de Curie est de ± 9 %.

12. Céramique à orientation cristalline selon l'une quelconque des revendications 1 à 11, dans laquelle le système cristallin est un système tétragonal sur une plage arbitraire de températures de 100 °C ou plus inférieure ou égale à la température de Curie.

13. Procédé de production de céramique à orientation cristalline, comprenant :

une étape de mélange dans laquelle une première poudre façonnée anisotrope, pour laquelle le plan de croissance présente une cohérence de réseau avec un plan cristallin spécifique du composé de pérovskite isotrope selon la revendication 1, est mélangée avec une première matière première de réaction qui réagit avec ladite première poudre façonnée anisotrope et forme au moins le composé de pérovskite isotrope ;

une étape de moulage dans laquelle le mélange obtenu dans l'étape de mélange est moulé de façon que la première poudre façonnée anisotrope soit orientée ; et

une étape de traitement thermique dans laquelle le produit moulé obtenu dans l'étape de moulage est chauffé pour provoquer une réaction entre la première poudre façonnée anisotrope et la première matière première de réaction.

**14.** Procédé de production de céramique à orientation cristalline selon la revendication 13, dans lequel la première poudre façonnée anisotrope est une poudre de type lamelle possédant, comme plan de croissance, le plan pseudo-cubique {100} et est représentée par la formule générale suivante :

$$\{Li_x(K_{1-y}Na_y)_{1-x}\}\{Nb_{1-z-w}Ta_zSb_w\}O_3 \text{ (où x, y, z et w sont } 0 \leq x \leq 1, 0 \leq y \leq 1, 0 \leq z \leq 1 \text{ et } 0 \leq w \leq 1, \text{respectivement).}$$

**15.** Elément piézoélectrique composé d'un matériau piézoélectrique composé de céramique à orientation cristalline selon l'une quelconque des revendications 1 à 12.

**16.** Elément diélectrique composé d'un matériau diélectrique composé de céramique à orientation cristalline selon l'une quelconque des revendications 1 à 12.

**17.** Elément de conversion thermoélectrique composé d'un matériau de conversion thermoélectrique composé de céramique à orientation cristalline selon l'une quelconque des revendications 1 à 12.

**18.** Elément conducteur d'ions composé d'un matériau conducteur d'ion composé de céramique à orientation cristalline selon l'une quelconque des revendications 1 à 12.

# Fig.1

EXAMPLE 1

DEGREE OF
ORIENTATION:82%

# Fig.2

EXAMPLE 3

DEGREE OF
ORIENTATION:81%

# Fig.3(a)

# Fig.3(b)

# Fig.4

EXAMPLE 2

COMPARATIVE EXAMPLE 1

# Fig.5

EXAMPLE 7

COMPARATIVE EXAMPLE 3

# Fig.6

# Fig.7

# Fig.8

# Fig.9

# Fig.10

# Fig.11

## Fig.12

ELECTRIC FIELD:0~+1500V/mm

EXAMPLE 22

$D_{33large}$ (pm/V) vs TEMPERATURE (°C)

## Fig.13

ELECTRIC FIELD:0~+2000V/mm

EXAMPLE 23

$D_{33large}$ (pm/V) vs TEMPERATURE (°C)

# Fig.14

## Fig.15

## Fig.16

## Fig.17

## Fig.18

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11180769 A
- JP 2000272962 A
- JP 2000281443 A
- JP 2000313664 A
- JP 2002137966 A
- JP 2001240471 A
- JP 2001291908 A
- JP 2001039766 A
- JP 2002193663 A
- JP 11060333 A
- JP 58060582 A
- EP 1032057 A1
- JP 49033907 A
- JP 7082024 A